# EUROPÄISCHE PATENTSCHRIFT

(11) **EP 2 472 688 B1**
(45) Veröffentlichungstag und Bekanntmachung des Hinweises auf die Patenterteilung: **31.07.2019**
(21) Anmeldenummer: 11192353.8
(22) Anmeldetag: 07.12.2011
(51) Int. Cl.: G01D 5/26, G01R 31/12, G01D 5/353, H02G 15/068, H02G 15/105, H02G 1/00

(54) **Hochspannungseinrichtung und Verfahren zum Monitoring von Alterungsprozessen einer Isolierung in einer Hochspannungseinrichtung**
High voltage device and method for monitoring degradation of insulation in a high voltage device
Installation à haute tension et procédé de surveillance de processus de vieillissement d'un isolant dans une installation à haute tension

(30) Priorität: 28.12.2010 DE 102010061607
(43) Veröffentlichungstag der Anmeldung: 04.07.2012
(73) Patentinhaber: BAM Bundesanstalt für Materialforschung und -prüfung, 12205 Berlin (DE); IPH Institut "Prüffeld für elektrische Hochleistungstechnik" GmbH, 10681 Berlin (DE)
(72) Erfinder: Habel, Wolfgang, 13125 Berlin (DE); Heidmann, Gerd, 10319 Berlin (DE)
(74) Vertreter: Zimmermann & Partner Patentanwälte mbB

(56) Entgegenhaltungen:
- EP-A2- 0 411 863
- WO-A1-98/40756
- DE-A1- 1 490 580
- DE-A1- 19 514 852
- DE-A1-102009 007 142
- JP-A- H03 128 471
- US-A1- 2005 134 837
- US-B1- 6 300 767
- BANJI ET AL: "Electroluminescence - a technique to detect the initiation of degradation in polymeric insulation", 1. Juni 1999 (1999-06-01), 19990601; 19990600, PAGE(S) 9 - 14, XP011084569, * Seite 11, Absatz 3 *

## Beschreibung

Die vorliegende Erfindung betrifft ein Verfahren zum Monitoring von Alterungsprozessen einer Isolierung in Hochspannungseinrichtungen sowie eine zugehörige Hochspannungseinrichtung.

In der DE 102009007142 A1 wird eine faseroptische Meßvorrichtung zum Erfassen von Belastungszuständen von Nieder-und Mittelspannungskabeln, insbesondere von Energiekabeln von Kühlcontainern und Offshore-Windkraftanlagen beschrieben. Diese faseroptische Messvorrichtung hat eine Anzahl von Sensoren, welche in die Kabel integriert sind und eine mechanische Belastung des Kabels bzw. der Faser, insbesondere durch eine Biegung oder Verteilung, eine Temperatur und/oder kursive Gase erfassen können. Die Sensoren werden mit Licht einer externen Quelle gespeist und bilden ein faseroptisches Sensometzwerk. Weiterer Stand der Technik ist in US/2005/134837 A1 zu finden.

In elektrischen Anlagen zur Energieversorgung kommt es auf Grund von schädigenden Einflüssen auf die Hochspannungsgarnitur und Alterungserscheinungen der Isolierungen immer wieder zu Ausfällen. Hauptsächlich werden diese Ausfälle durch Teilentladungen verursacht. Während der Teilentladungen entstehen sogenannte Teilentladungsbäumchen, die im Laufe der Zeit wachsen und schließlich zu einem elektrischen Durchschlag führen, falls die betroffenen Anlagen nicht rechtzeitig abgeschaltet werden. Teilentladungen in Isolierungen von Kabelgarnituren, wie Endverschlüsse und Kabelmuffen für Starkstromkabel bzw. Hochspannungskabel, können in fortgeschrittenem Stadium daher zur Totalzerstörung der Kabelgarnituren führen. Auf Grund der mit dem Durchschlag verbundenen hohen Energiefreisetzung können dabei weitere Teile der Anlagen beschädigt werden. Die Schäden dieser zwar eher seltenen Ereignisse können daher beträchtlich sein. Daher besteht ein Bedarf, Alterungserscheinungen bzw. Teilentladungen in Isolierungen von Hochspannungsgarnituren möglichst im laufenden Betrieb zuverlässig zu detektieren und zu bewerten.

Eine bisher etablierte Methode besteht in der Messung elektrischer Stromimpulse und/oder elektromagnetischer Signale, die mit dem Auftreten von Teilentladungen verbunden sind. Die Interpretation dieser Messergebnisse ist unter Praxisbedingungen wegen elektromagnetischer Störungen jedoch häufig schwierig. Außerdem sind diese Messungen sehr aufwendig und erfordern typischerweise den Aufbau geeigneter Mess- und Prüfanlagen vor Ort. Daher erfolgt die Überwachung typischerweise nur in größeren Zeitabständen oder bei Vermutung entstehender Schädigungen. Zudem wird die Messempfindlichkeit von elektromagnetischen Umweltstörungen begrenzt, so dass Teilentladungen erst in einem späten Stadium, d.h. kurz vor dem Durchbruch, erfasst werden. Elektromagnetische Messungen können nämlich nur in sicheren Zugangsbereichen, d.h. außerhalb des Hochspannungsbereichs, durchgeführt werden. Auf Grund des höheren Abstands zum Ort der Teilentladung können daher nur Teilentladungen ab einer bestimmten Intensität detektiert werden.

Außerdem können mit derartigen elektrischen oder elektromagnetischen Messungen die einer Teilentladung typischerweise vorausgehenden Schädigungen der Isolierungen nicht detektiert werden. Dies wäre aber für eine Prognose des Ermüdungs- bzw. Alterungszustandes der Isolierung häufig wünschenswert.

Gemäß der gängigen Vorstellung verändert sich ein polymeres Isoliermaterial im Hochspannungswechselfeld in mehreren Stufen. Dabei wird typischerweise von einem dreistufigen phänomenologischen Alterungsmodell polymerer Isolierungen ausgegangen, das den Teilentladungsprozess als dritte Stufe einschließt. In der ersten Stufe erfolgt eine Bereitstellung von Ladungsträgern, die je nach Material und Feldverteilung durch eine charakteristische kritische Feldstärke gekennzeichnet ist. Dieser Prozess kann im Isolierstoffvolumen überall dort ablaufen, wo infolge z.B. herstellungsbedingter Inhomogenitäten die kritische Feldstärke überschritten wird. Er kann aber auch an der Grenzfläche zum stromführenden Leiter stattfinden. Die zweite Modellstufe ist dadurch charakterisiert, dass mit dem Beginn der Ladungsträgerinjektion ein Energietransfer vom elektrischen Feld über die injizierten Ladungsträger auf die Polymermatrix stattfindet. Materialabhängige und herstellungsbedingte Inhomogenitäten spielen hierbei eine zentrale Rolle, da sie als Startpunkte der nun einsetzenden irreversiblen Schädigungsmechanismen dienen. Durch die Ladungsträgerinjektion in den jeweiligen Halbschwingungen des Hochspannungswechselfelds kommt es zu einem Raumladungsaufbau in Haftstellen. Dabei kann es zu Elektrolumineszenz-erscheinungen kommen. Das Auftreten von Elektrolumineszenz in dieser Phase kann durch sogenannte "hot-electron"-Prozessen, durch Anregung von Molekülen, und durch Ladungsträgerrekombinationen verursacht werden. Welche dieser Prozesse ggf. dominieren, ist vom Material abhängig. Der Energietransfer über die injizierten Ladungsträger führt zu irreversiblen chemischen, mechanischen und thermischen Veränderungen des Polymergefüges. Dabei wird der lokale Feldstärkeverlauf durch Raumladungsrückwirkungen typischerweise stark beeinflusst. Anschließend kann es zur Ausbildung von Mikrohohlräumen kommen, in der nach Überschreiten einer kritischen Größe Teilentladungen zünden, womit die dritte Stufe erreicht ist.

Im weiteren Verlauf können dann immer stärkere Teilentladungen auftreten, die zu wachsenden Teilentladungsbäumchen und schließlich zum unerwünschten elektrischen Durchbruch führen können.

Im Hinblick auf das oben Gesagte, schlägt die vorliegende Erfindung ein Verfahren gemäß Anspruch 1 und eine Hochspannungseinrichtung gemäß Anspruch 9 vor.

Gemäß einem Ausführungsbeispiel wird ein Verfahren zum Monitoring von Alterungsprozessen einer Isolierung in einer Hochspannungseinrichtung bereitgestellt. Das Verfahren weist dabei den Schritt der Messung eines in der Isolierung erzeugten Lichtsignals mit einem ersten faseroptischen Sensor, sowie den Schritt der Messung einer mechanischen Größe der Isolierung mit einem zweiten faseroptischen Sensor auf. Die Isolierung umfasst dazu zumindest ein transparentes oder transluzentes Teilgebiet, in das der erste faseroptische Sensor zumindest teilweise eingebettet ist und/oder auf dessen Oberfläche der erste faseroptische Sensor zumindest teilweise angeordnet ist. Dabei beziehen sich die Begriffe der Transparenz und Transluzenz auf erwartete Wellenlängen und/oder Wellenlängenbereiche des in der Isolierung erzeugten Lichtsignals. Bei dem in der Isolierung erzeugten Lichtsignal kann es sich beispielsweise um eine Elektrolumineszenzerscheinung, z.B. im nahen Infrarotbereich bis in den sichtbaren Wellenlängenbereich, aber auch um eine von einer Teilentladung erzeugte Lichterscheinung, z.B. im sichtbaren Lichtbereich bis in den UV-Bereich, handeln. Typischerweise hat das transparente oder transluzente Teilgebiet einen für die Detektion hinreichend niedrigen Absorptionskoeffizient für zumindest eine Wellenlänge aus dem erwarteten Elektrolumineszenzspektrum und/oder für zumindest eine Wellenlänge aus dem erwarteten optischen Spektrum einer Teilentladung. Unter dem Begriff der "Messung eines in der Isolierung erzeugten Lichtsignals" wie er vorliegend verwendet wird, soll insbesondere eine Messung einer optischen Größe, die ein Maß für das Auftreten einer Elektrolumineszenzerscheinung und/oder einer Entladungserscheinung in der Isolierung im Hochspannungsfeld darstellt, verstanden werden. Die Messung einer mechanischen Größe liefert typischerweise ein Maß für eine in der Isolierung auftretende Teilentladung. Sie kann aber auch ein Maß für eine einer Teilentladung vorangehende Veränderung, z.B. für eine Setzungserscheinung in der Isolierung liefern. Außerdem erfolgt eine Abschätzung eines Alterungszustandes der Isolierung. Dies ermöglicht eine einfache und/oder fehlertolerante und/oder sehr empfindliche Überwachung des Alterungszustandes der Isolierung.

Der Begriff "Hochspannung", wie er vorliegend verwendet wird, soll Spannungen oberhalb von etwa 1 kV umfassen, insbesondere soll der Begriff Hochspannung die in der Energieübertragung üblichen Nennspannungsbereiche der Mittelspannung von etwa 3 kV bis etwa 50 kV, der Hochspannung von etwa 50 kV bis etwa 110 kV als auch Höchstspannungen bis derzeit etwa 500 kV umfassen. Für den Fall, dass die Kabelbetriebsspannungen weiter erhöht werden, sollen auch diese Spannungsbereiche mit umfasst werden. Dabei kann es sich sowohl um Gleichspannungen als auch um Wechselspannungen handeln. Der Begriff "Hochspannungskabel", wie er vorliegend verwendet wird, soll ein Kabel beschreiben, das dazu geeignet ist, Starkstrom, d.h. elektrischen Strom von mehr als etwa einem Ampère bei Spannungen oberhalb von etwa 1 kV, zu führen. Im Folgenden werden die Begriffe Hochspannungskabel und Starkstromkabel synonym verwendet. Dementsprechend soll der Begriff der "Hochspannungsgarnitur" oder "Hochspannungskabelgarnitur" eine Vorrichtung beschreiben, die geeignet ist, Hochspannungsanlagen und/oder Hochspannungskabel miteinander zu verbinden.

Der Begriff "Teilentladung", wie er vorliegend verwendet wird, soll kurzzeitige, energiearme und lokal begrenzte Entladungen in der Isolierung, die nicht sofort zu einem elektrischen Durchschlag führen, aber das Material der Isolierung irreversibel schädigen, beschreiben. Der Begriff "Teilentladung" soll insbesondere den Begriff der "inneren Teilentladung", d.h. einer äußerlich nicht unbedingt sichtbaren Entladungserscheinungen in nicht gasförmigen Isoliermaterialien, insbesondere in festen Isoliermaterialien, umfassen. Ausgehend von Fehlstellen, wie Hohlräumen und Fremdeinschlüssen oder Grenzflächen zu anderen Materialien, insbesondere zu hochspannungsführenden Leitern, führen Teilentladungen zu im Laufe der Zeit wachsenden Teilentladungsbäumchen im Isoliermaterial, was schließlich zu einem Durchschlag führen kann. Teilentladungsbäumchen haben typischerweise eine Größe von mehr als etwa 1 µm (Mikrometer).

Als Maß für die Stärke einer Teilentladung kann die direkt an den Prüfanschlüssen einer elektrischen Messanordnung messbare scheinbare Ladung verwendet werden. Mit etablierten elektrischen und elektromagnetischen Meßmethoden können gegenwärtig unter in der Praxis üblichen Testbedingungen Teilentladungen mit einer scheinbaren Ladung von mehr als etwa 1 pC nachgewiesen werden. Die Industrienorm IEC 60840 Ed. 3, 2004-04 fordert für die Prüfung von Hochspannungsanlagen eine Messgenauigkeit von etwa 5 pC. Im Hochspannungsbetrieb der Hochspannungseinrichtung wird die Messempfindlichkeit dieser Methoden durch elektromagnetische Grundstörpegel jedoch auf einen Bereich von etwa 20 pC bis etwa 50 pC begrenzt. Der Begriff "Teilentladung", wie er vorliegend verwendet wird, soll insbesondere Entladungen in der Isolierung mit scheinbaren Ladungen, d.h. elektrisch messbaren scheinbaren Ladungen, von mehr als ca. 1 pC umfassen. Der Begriff "Teilentladung", wie er vorliegend verwendet wird, soll aber auch sogenannte "Impulslose Teilentladungen" umfassen, die derzeit mit den etablierten elektrischen und elektromagnetischen Meßmethoden zwar an Proben unter Laborbedingungen, jedoch noch nicht an technischen Anlagen wie Hochspannungseinrichtungen nachweisbar sind.

Teilentladungen können von Elektrolumineszenzerscheinungen im Hochspannungsfeld durch ihr stark stochastisches Entladungsverhalten, das Wachstum der Teilentladungsbäumchen auch bei konstanter Feldstärke, sowie je nach Material der Isolierung und Feldstärke durch ein ggf. abweichendes Frequenzspektrum und/oder die typischerweise verschiedene Lichtintensität unterschieden werden. Die Lichtintensität von Elektrolumineszenzphänomenen von Isoliermaterialien ist im Hochspannungsfeld bei gleicher elektrischer Feldstärke typischerweise schwächer als die Lichtintensität einer Teilentladung, insbesondere für Teilentladungen mit scheinbaren Ladungen von mehr als ca. 1 pC. Außerdem ist die Elektrolumineszenz typischerweise durch reproduzierbare Intensitätswerte bei gleichen Feldstärken gekennzeichnet, wobei die Intensität nahezu unabhängig von der Vorgeschichte ist.

Gemäß einer Weiterbildung umfasst die Messung eines in der Isolierung erzeugten Lichtsignals die Messung einer Lichtintensität, einer Lichtwellenlänge und/oder einer Pulsdauer einer in einem Feldsteuerteil der Isolierung auftretenden Elektrolumineszenzerscheinung und/oder einer in dem Feldsteuerteil auftretenden Entladungserscheinung mit einer scheinbaren Ladung von weniger als etwa 5 pC, weniger als etwa 2 pC und sogar weniger als etwa 1 pC. Damit können auch Elektrolumineszenzerscheinung und/oder Entladungserscheinung erfasst werden, die mit der von der Industriemorm IEC 60840 geforderten Messgenaugigkeit für Entladungserscheinung nicht erfasst werden können. Über die Messung eines in der Isolierung erzeugten Lichtsignals können somit frühe Alterungszustände der Isolierung überwacht werden. Dies erlaubt eine wesentlich frühere und/oder genauere Abschätzung des Alterungszustandes der Isolierung.

Die Messung eines in der Isolierung erzeugten Lichtsignals kann aber auch die Messung einer Teilentladungserscheinung, d.h. von Entladungserscheinungen mit einer scheinbaren Ladung von mehr als etwa 5 pC mit umfassen. Dies ermöglicht eine einfache Detektion von Teilentladungsprozessen und damit eines fortgeschritteneren Alterungszustandes der Isolierung.

Je nach Stärke sind Teilentladungen zudem mit kurzen Schallemissionen im Bereich von etwa 10 kHz bis etwa einigen Hundert kHz verbunden, die vom zweiten faseroptischen Sensor detektiert werden können. Durch elektrochemische Veränderungen (Reaktionsschwund) und/oder während der Teilentladungen können sich außerdem mechanische Spannungen entwickeln und in deren Folge Risse und Spalten im Isoliermaterial bilden. Die Messung einer mechanischen Größe umfasst typischerweise die Messung einer Veränderung einer mechanischen Eigenschaft der Isolierung und/oder einer in der Isolierung auftretenden Schwingung. Bei der mechanischen Größe der Isolierung kann es sich um eine Ausdehnung der Isolierung, eine Dichte der Isolierung, einen Druck bzw. eine mechanische Spannung in der Isolierung, eine Deformation der Isolierung, eine eine mechanische Schwingung der Isolierung charakterisierende Größe und/oder eine Größe handeln, die eine sich in der Isolierung ausbreitende und/oder von Isolierung ausgehende mechanische Welle, d.h. eine Schallwelle, charakterisiert. Die mechanische Größe kann insbesondere eine Schallfrequenz, einen Schalldruckpegel, eine Schalldauer, und/oder eine Schallintensität eines in der Isolierung von elektrischen Teilentladungen erzeugten Schallereignisses umfassen. Dies ermöglicht eine einfache Detektion von Teilentladungsprozessen und damit eines fortgeschritteneren Alterungszustandes der Isolierung.

Durch die Verwendung des ersten faseroptischen Sensors und des zweiten faseroptischen Sensors können Veränderungen der Isolierung von einem Frühstadium bis hin zu Teilentladungen ohne aufwendige externe Messaufbauten detektiert werden. Faseroptische Sensoren können nämlich zum Einen hochempfindlich ausgeführt werden, zum Anderen können sie aus ausschließlich dielektrischen Materialien gefertigt werden, so dass sie prinzipiell im Hochspannungsfeld, d.h. nahe teilentladungsgefährdeter Gebiete oder sogar in teilentladungsgefährdeten Gebieten, eingesetzt werden können, ohne das Hochspannungsfeld signifikant zu verändern. Dies ermöglicht zudem eine einfache kontinuierliche Überwachung des Zustands der Isolierung während des Betriebs der Hochspannungsgarnitur, bspw. durch Übermittlung der Messergebnisse an eine zentrale Auswerteeinheit. So können ein drohender Durchschlag in der Hochspannungsgarnitur frühzeitig erkannt, die Anlage abgeschaltet und durch Austausch der gealterten Isolierung oder der kompletten Hochspannungsgarnitur Folgeschäden vermieden werden.

Insbesondere kann das Verfahren zum Monitoring von Alterungsprozessen der Isolierung einer Hochspannungskabelgarnitur, beispielsweise einer Kabelmuffe oder eines Kabelendverschlusses, eingesetzt werden. Die Isolierungen in Kabelmuffen und Kabelendverschlüssen sind insbesondere in der Nähe von Leiterenden und/oder in der Nähe von Öffnungen der Kabelisolierung typischerweise hohen elektrischen Feldstärken ausgesetzt. Eine Überwachung von Alterungsprozessen bei diesen Vorrichtungen kann daher besonders zur Erhöhung der Betriebssicherheit beitragen.

In die Abschätzung des Alterungszustandes der Isolierung können neben einzelnen Messungen einer mechanischen Größe und/oder einzelnen Messung eines in der Isolierung erzeugten Lichtsignals auch deren zeitliche Entwicklung eingehen. Damit kann eine verbesserte Prognosegenauigkeit erreicht werden.

Typischerweise wird bei der Detektion eines Schallereignisses in der Isolierung der Schalldruck und/oder eine Schallfrequenz und/oder die Schalldauer zum Abschätzen des Alterungszustandes der Isolierung berücksichtigt. Diese Werte lassen sich einfach bestimmen und gut zur Charakterisierung von Teilentladungen geeignet.

Analog wird typischerweise bei der Detektion eines Lichtsignals in der Isolierung dessen integrale Lichtintensität und/oder ein Maß für die Fluktuation der Lichtintensität zum Abschätzen des Alterungszustandes der Isolierung berücksichtigt. Diese Werte lassen sich ebenfalls einfach bestimmen und sind gut zur Charakterisierung von Teilentladungen und Elektrolumimeszenzerscheinungen bzw. deren Unterscheidung geeignet.

Es ist aber auch möglich, zum Abschätzen des Alterungszustandes der Isolierung aufwendiger zu bestimmende Größen, wie die Länge eines Teilentladungsbäumchens in der Isolierung zu verwenden. Zwar werden dazu Daten von mehreren ersten und/oder zweiten faseroptischen Sensoren benötig. Dafür ist die Länge eines Teilentladungsbäumchens aber besonders ein besonders relevanter Parameter, um einen fortgeschritteneren Alterungszustand der Isolierung zu charakterisieren.

Gemäß einer Weiterbildung erfolgt das Abschätzen eines Alterungszustandes der Isolierung in einer zentralen Auswerteeinheit. Typischerweise überwacht die zentrale Auswerteeinheit dabei mehrere Isolierungen, zum Beispiel sämtliche Isolierungen in Kabelmuffen und Kabelendverschlüssen einer Hochspannungseinrichtung, bspw. eines Spannungsnetzes.

Gemäß noch einer Weiterbildung wird ein Warnhinweis oder ein Warnsignal ausgegeben, wenn der Alterungszustand der Isolierung einen vorgegebenen Schwellenwert überschreitet.

Damit kann sichergestellt werden, dass eine Reparatur oder ein Austausch der betroffenen Komponente rechtzeitig vor einem Durchbruch initiiert wird.

Gemäß einer Weiterbildung wird das Verfahren kontinuierlich und/oder ereignisgesteuert ausgeführt, wobei ein oder mehrere Sensoren betrieben werden können. Damit soll sichergestellt werden, dass sämtliche auftretenden Teilentladungen bzw. andere schädigende Einflüsse erfasst werden. Unter dem Begriff einer "zeitlich kontinuierlichen Messung", wie er vorliegend verwendet wird, soll eine Messung verstanden werden, die auch einzelne kurze Signale im Bereich oberhalb einiger Millisekunden in einem Zeitraum von mehreren Stunden, typischerweise mehreren Tagen, oder sogar mehreren Wochen und Monaten detektieren kann. Das Verfahren kann bspw. so ausgeführt werden, dass ein mit dem ersten faseroptischen Sensor verbundener erster Detektor und ein mit dem zweiten faseroptischen Sensor verbundener zweiter Detektor während eines bis über Monate andauernden Zeitraums durchgängig die vom jeweiligen faseroptischen Sensor gelieferten optischen Signale detektiert, die eigentliche Auswertung der Messung bzw. Bestimmung der damit korrelierten optischen bzw. mechanischen Größe in einer Auswerteinheit jedoch nur bei einer Änderung der Signale erfolgt, d.h., wenn sich z.B. die mechanische Größe durch ein Ereignis, wie eine elektrische Teilentladung, geändert hat. Die eigentliche Auswertung der Messung bzw. Bestimmung der damit korrelierten optischen und/oder mechanischen Größen kann aber auch in periodischen Abständen erfolgen. Durch die kontinuierlichen und/oder ereignisgesteuerten Messung mittels des ersten faseroptischen Sensors und des zweiten faseroptischen Sensors kann eine lückenlose Überwachung von feldinduzierten Lichterscheinungen in der Isolierung und von mechanischen Veränderungen und/oder Schallereignissen in der Isolierung gewährleistet werden.

Gemäß einer Ausführungsform umfasst ein Verfahren zum Monitoring von Alterungsprozessen einer Isolierung die Schritte der Überwachung von in der Isolierung erzeugten Lichtsignalen mit einem ersten faseroptischen Sensor, die Überwachung von Deformationen der Isolierung und/oder Schallereignissen in der Isolierung mit einem zweiten faseroptischen Sensor, und das Abschätzen eines Alterungszustandes der Isolierung. Typischerweise wird dieses Verfahren im laufenden Betrieb der Hochspannungseinrichtung, z.B. einer Kabelgarnitur, d.h. unter Hochspannungsbedingungen, ausgeführt.

Gemäß noch einem Ausführungsbeispiel wird eine Hochspannungseinrichtung angegeben. Die Hochspannungseinrichtung ist so ausgeführt, dass ein Hochspannungskabel mit einem zum Leiten elektrischen Stroms eingerichteten Leiter und einer den Leiter umgebenden Kabelisolierung aufnehmen kann. Die Hochspannungseinrichtung umfasst eine Isolierung, die so ausgebildet ist, dass sie die Kabelisolierung zumindest teilweise umgeben kann. Die Hochspannungseinrichtung umfasst ferner einen ersten faseroptischen Sensor, der zumindest teilweise im Innern der Hochspannungseinrichtung angeordnet ist und einen mit der Isolierung mechanisch gekoppelten zweiten faseroptischen Sensor. Der erste faseroptische Sensor ist so eingerichtet, dass er ein optisches Signal detektieren kann. Dabei kann der erste faseroptische Sensor eingerichtet sein, eine Elektrolumineszenz und/oder eine Entladungserscheinung mit einer scheinbaren Ladung von weniger als etwa 5 pC, weniger als etwa 2 pC oder sogar weniger als 1 pC zu detektieren. Beispielsweise kann der erste faseroptische Sensor eine Messempfindlichkeit aufweisen, die eine zuverlässige Signaldetektion ermöglicht, wobei eine elektrische Messung noch keine auswertbaren Ergebnisse liefert. Dies wird bei scheinbaren Ladungen kleiner 1pC bis etwa 0.1 pC auftreten. Damit können Elektrolumineszenz und/oder eine Entladungserscheinung im Hochspannungsbetrieb deutlich früher, typischerweise mindestens 10-mal empfindlicher, als mit etablierten elektrischen und elektromagnetischen Meßmethoden nachgewiesen werden. Der zweite faseroptische Sensor ist so eingerichtet, dass er eine mechanische Größe detektieren kann. Damit kann mit dem zweiten faseroptischen Sensor eine in der Isolierung auftretende elektrische Teilentladung über eine mit der Teilentladung verbundene Deformation, und/oder eine Schwingung der Isolierung nachgewiesen werden. Typischerweise ist der zweite faseroptische Sensor eingerichtet eine Schallwelle in der Isolierung zu detektieren. Durch Verwendung des ersten faseroptischen Sensors und des zweiten faseroptischen Sensors kann somit ein Nachweis von Veränderungen der Isolierung von einem sehr frühen Stadium vor dem Einsetzen von Teilentladungen mittels des ersten faseroptischen Sensors bis in den Teilentladungsbereich mittels des zweiten faseroptischen Sensors gewährleistet werden.

Gemäß noch einem Ausführungsbeispiel handelt es sich bei der Hochspannungseinrichtung um eine Schaltanlage, z.B. einen Schaltschrank, eine Kabelmuffe oder einen Kabelendverschluss, deren jeweilige Isolierung besonders hohen Feldstärken ausgesetzt und somit besonders teilentladungsgefährdet ist. Bei der Hochspannungseinrichtung kann es sich aber auch um einen Generator, einen Spannungswandler, z.B. einen Wechselrichter oder einen Transformator handeln.

Gemäß der Erfindung umfasst die Hochspannungsgarnitur ein zumindest in Teilgebieten transparentes oder transluzentes Feldsteuerteil, das eingerichtet ist, die Kabelisolierung des Hochspannungskabels zumindest teilweise zu umgeben. Typischerweise ist das Feldsteuerteil ein transparenter oder tranzluzenter elastomerer Feldsteuerkörper mit integriertem Deflektor zur Veränderung des elektrischen Feldverlaufs in Hochspannungseinrichtungen wie Kabelgarnituren. Das Feldsteuerteil nimmt dazu typischerweise denjenigen Raum in der Hochspannungseinrichtung ein, in dem die Feldstärke im Hochspannungsbetrieb zu groß für die übrige Isolierung ist. Das Feldsteuerteil kann insbesondere als Feldsteuerkonus mit einem integrierten leitfähigen Deflektor ausgebildet sein. Damit kann das Feldsteuerteil die Feldlinien im Hochspannungsbetrieb der Hochspannungseinrichtung so führen, dass die Feldstärke außerhalb des Feldsteuerteils hinreichend niedrig ist. Der leitfähige Deflektor kann einen hohen Absorptionskoeffizient im erwarteten Wellenlängenbereich der Elektrolumineszenzerscheinung und/oder Entladungserscheinung aufweisen und stellt dann einen im Wesentlichen nichttransparenten Teil des Feldsteuerteils dar.

Gemäß noch einem Ausführungsbeispiel umfasst der erste faseroptische Sensor eine mit einem Fluophor dotierte Lichtfaser, typischerweise eine polymere Lichtfaser mit dotiertem Kern, und einen auf ein Emissionswellenspektrum des Fluophors abgestimmtem und mit der dotierten Lichtfaser gekoppelten optischen Detektor. Dabei ist die dotierte Lichtfaser zumindest teilweise in einen transparenten oder tranzluzenten Teil der Isolierung eingebettet und/oder auf einer Oberfläche des transparenten oder tranzluzenten Teils der Isolierung angeordnet. Dadurch wird eine hochempfindliche Messung von Lichtsignalen in der Isolierung ermöglicht.

Weitere vorteilhafte Ausgestaltungen, Einzelheiten, Aspekte und Merkmale der vorliegenden Erfindung ergeben sich aus den Unteransprüchen, der Beschreibung sowie den beigefügten Zeichnungen. Darin zeigt:
Fig. 1 einen schematischen Querschnitt einer Hochspannungsgarnitur einen gemäß einem Ausführungsbeispiel;
Fig. 2 einen schematischen Querschnitt einer Hochspannungsgarnitur gemäß einem weiteren Ausführungsbeispiel;
Fig. 3 einen schematischen Querschnitt einer Hochspannungsgarnitur gemäß noch einem weiteren Ausführungsbeispiel;
Fig. 4 einen schematischen Querschnitt einer Hochspannungsgarnitur gemäß noch einem weiteren Ausführungsbeispiel;
Fig. 5 einen schematischen Querschnitt einer Hochspannungsgarnitur gemäß einem weiteren Ausführungsbeispiel; und
Fig. 6 Schritte eines Verfahrens zum Monitoring von Alterungsprozessen einer Isolierung einer Hochspannungseinrichtung gemäß einem Ausführungsbeispiel.

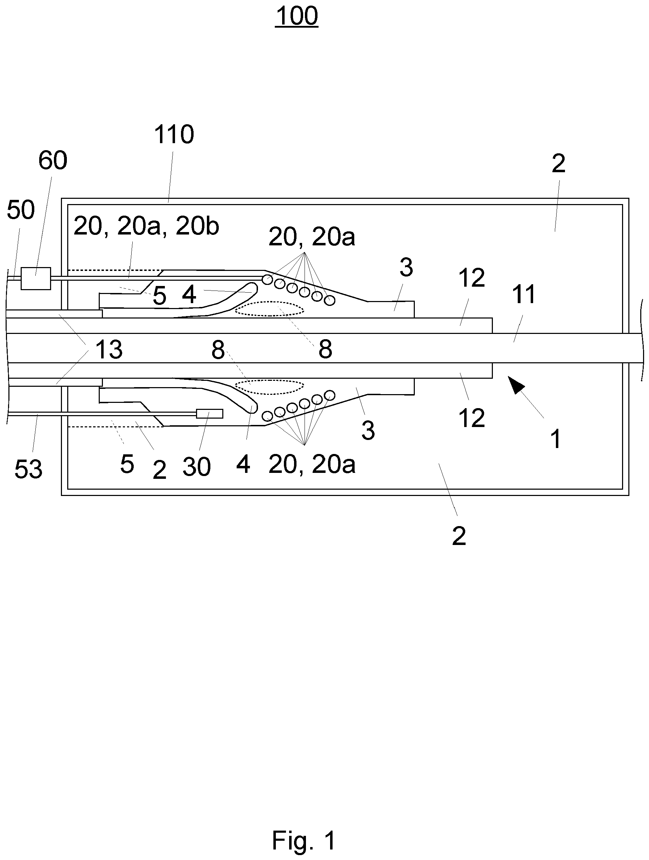

Fig. 1 zeigt eine Hochspannungsgarnitur 100 zur Aufnahme eines Hochspannungskabels 1 gemäß einem Ausführungsbeispiel in einer schematischen zentralen Querschnittsansicht entlang der Zylinderachse des Hochspannungskabels 1. Das rotationssymmetrische Hochspannungskabel 1 enthält im Innern einen Leiter 11 zum Leiten von Starkstrom, bspw. einen Aluminium- oder Kupferleiter, der von einer Kabelisolierung 12, typischerweise einer VPE-Isolierung (vernetztes Polyethylen), und einer äußeren Kabelschirmung 13, z.B. einer äußeren Leitschicht oder einem halbleitenden äußeren Kabelschirm, umgeben ist. Weiterhin kann das Hochspannungskabel 1 zusätzlich Polsterschichten und einen Kupferschirm und einen äußeren Mantel zum Schutz gegenüber Umwelteinflüssen aufweisen. Dabei kann es sich um einen Polyethylen-Mantel oder einen Mantel aus einem anderen halogenfreien Material handeln. Diese Komponenten sind in Fig. 1 und den folgenden Figuren aus Gründen der Übersichtlichkeit nicht dargestellt. Außerdem kann das Hochspannungskabel 1 eine innere Leitschicht zwischen dem Leiter 11 und der VPE-Isolierung aufweisen. Diese innere Leitschicht ist ebenfalls nicht dargestellt.

Die in Fig. 1 dargestellte Hochspannungsgarnitur 100 stellt einen Kabelendverschluss 100 dar, wie er z.B. bei Freileitungen verwendet wird. Der Kabelendverschluss 100 hat ein Gehäuse 110, z.B. ein Keramikgehäuse, das die inneren Teile der Hochspannungsgarnitur 1 gegenüber der Umgebung abschließt. Im Innern des Gehäuses ist ein Isoliergebiet 2 angeordnet. Das Isoliergebiet 2 kann z.B. durch einen mit Öl oder Gas gefüllten weitgehend transparenten Isolierraum gebildet werden. Das Isoliergebiet 2 bildet ein im Wesentlichen zylindersymmetrisches Gebiet.

An dem in den Kabelendverschluss eingeführten Hochspannungskabel 1 sind die äußeren Schichten (Kabelmantel, Polsterschichten und metallischer Schirm) entfernt, die typischerweise halbleitende äußere Kabelschirmung 13 bis in den Bereich des Feldsteuerteils weitergeführt und danach durch den Endverschluss hindurch bis zur Kopfarmatur nur noch die Kabelisolierung 12 mit dem Leiter 11 axial weitergeführt. Nur der Leiter 11 wird vollständig durch den Kabelendverschluss 100 geführt, um im rechten Bereich von Figur 1 nach Verlassen des Kabelendverschlusses 100 an die Freileitung angeschlossen zu werden. Im Innern des Kabelendverschlusses 100 ist der Leiter 11 nur im Bereich der entfernten Kabelisolierung vom Isoliergebiet 2 direkt umgeben. Zur Aufnahme des Hochspannungskabels 1 ist in das Isoliergebiet 2 ein rotationssymmetrisches elektrisch isolierendes Feldsteuerteil 3 eingesetzt, das denjenigen Raum innerhalb des Isoliergebietes 2 einnimmt, in dem die elektrische Feldstärke zu groß für die Isoliermaterialien im Isoliergebiet 2 wäre. Das Feldsteuerteil 3 verfügt über einen inneren Hohlzylinder, in den das Hochspannungskabel 1 eingeschoben werden kann. Beispielsweise kann das Feldsteuerteil 3 als Feldsteuerkonus ausgeführt sein. Typischerweise ist das Feldsteuerteil 3 ein elastomeres Feldsteuerteil, das aus einem transparenten oder transluzenten Elastomerkörper besteht, z.B. aus einem Silikonelastomerkörper mit hinreichend hoher Transparenz bei einer oder mehreren Wellenlängen aus einem Bereich von etwa 300 nm bis etwa 900 nm. Der innere Hohlzylinder ist typischerweise so dimensioniert, dass zwischen der Kabelisolierung 12 des eingeschobenen Kabels 1 und dem Feldsteuerteil 3 eine Presspassung vorliegt und das Feldsteuerteil 3 somit einen Stresskonus bildet. Das Isoliergebiet 2 und das Feldsteuerteil 3 bilden zusammen die Isolierung des Kabelendverschlusses 100.

Das Feldsteuerteil 3 und/oder das Hochspannungskabel 1 können zusätzlich, beispielsweise über Federn, am Gehäuse 110 oder in einem sich auf Erdpotential befindenden kabelnahen Bereich 5 des Isoliergebiets 2 fixiert werden, z.B. wenn das Isoliergebiets 2 durch einen Feststoffisolierkörper gebildet ist. Eine derartige Fixierung von Feldsteuerteil 3 und/oder Hochspannungskabel 1 wird typischerweise bei einem Aufbau des Kabelendverschlusses 100 in Komponentenbauweise verwendet. Alternativ dazu kann der Aufbau des Kabelendverschlusses 100 auch entsprechend der Wickeltechnik oder Aufschiebetechnik ausgeführt sein. Die Isolierung umfasst unabhängig von der verwendeten Bauweise ein Feldsteuerteil 3 zur Aufnahme des Kabels 1 mit teilweise entfernter Kabelisolierung 12 und zur geeigneten Führung der Feldlinien im Hochspannungsbetrieb.

Für den Abbau des elektrischen Feldes wird typischerweise ein elastomerer Feldsteuerteil 3 verwendet, in das ein geeignet geformter leitfähiger Deflektor 4 integriert ist. Der leitfähige Deflektor 4 ist in elektrischem Kontakt mit der Kabelschirmung 13. Typischerweise besteht der leitfähige Deflektor 4 ebenfalls aus einem Silikoneleastomer, der jedoch durch Dotierung über eine geeignete elektrische Leitfähigkeit verfügt. Aufgrund von Materialinhomogenitäten oder Fehlern gibt es typischerweise Bereiche erhöhter Feldstärke. Diese werden in Fig. 1 von den gestrichelt umrandeten Bereichen 8 repräsentiert. Die Wahrscheinlichkeit für das Auftreten bzw. Einsetzen von Teilentladungen ist in den Bereichen 8 mit erhöhter Feldstärke erhöht.

Gemäß einem Ausführungsbeispiel sind im Innern der Hochspannungsgarnitur 100 ein erster faseroptischer Sensor 20 und ein zweiter faseroptischer Sensor 30 angeordnet. Beide faseroptische Sensoren 20, 30 der Hochspannungsgarnitur 100 sind zumindest teilweise in einem transparenten oder zumindest transluzenten Elastomerkörper 3, z.B. einem entsprechenden Silikonelastomerkörper, eingebettet, der die Isolierung 12 des Hochspannungskabels 1 und dessen Leiter 11 teilweise umgibt. Der Elastomerkörper 3 stellt damit zumindest einen Teil einer Isolierung der Hochspannungsgarnitur 100 dar.

Bei dem ersten faseroptischen Sensor 20 handelt es sich um einen Sensor zur Detektion eines optischen Signals bzw. Lichtsignals, das im Elastomerkörper 3 im Hochspannungsfeld auf Grund von hochspannungsfeldinduzierten und ladungsträgervermittelten Veränderungsprozessen entstehen kann. Der erste faseroptische Sensor 20 kann insbesondere eingerichtet sein, ein Elektrolumineszenzsignal und/oder ein von einer Entladungserscheinung ausgehendes Lichtsignal mit scheinbaren Ladungen bis unterhalb von 5 pC oder darunter zu detektieren. Der erste faseroptische Sensor 20 ist typischerweise ein sogenannter "FOF-Sensor", d.h. das er eine fluoreszenzoptische Lichtleitfaser 20a (engl. "fluorescent optical fiber"), typischerweise eine polymere fluoreszenzoptische Lichtleitfaser (engl. "fluorescent plastic optical fiber") mit dotiertem Kern und einen auf Emissionswellenspektrum des Fluophors des dotierten Kerns abgestimmtem und mit der fluoreszenzoptischen Lichtleitfaser 20a gekoppelten optischen Detektor umfasst. Typischerweise ist das Absorptionswellenspektrum des Fluophors auf das erwartete Spektrum des Lichtsignals im Elastomerkörper abgestimmt. Damit kann ein extrem empfindlicher Sensor für optische Signale bereitgestellt werden. Außerdem ist die fluoreszenzoptische Lichtleitfaser 20a typischerweise mit einer Vielzahl von Windungen um den Bereich 8 mit erhöhter Feldstärke angeordnet, z.B. in Form einer Spiralhelix wie in Fig. 1 schematisch gezeigt, so dass viel Licht aus dem besonders gefährdetem Bereich 8 gesammelt, über die Fluophore in langwelligeres Licht umgewandelt und dieses dem nicht dargestelltem Detektor in einer Auswerteeinheit 60 zugeführt werden kann. Dabei ist zumindest ein Ende der fluoreszenzoptischen Lichtleitfaser 20a mit dem Detektor verbunden. Die Auswerteeinheit 60 befindet sich typischerweise in einem feldfreien Raum 5 bzw. außerhalb des Endverschlussgehäuses 110. Damit ist kann der Detektor weitgehend vor elektromagnetischen Störungen des Hochspannungsfelds geschützt werden. Bei dem Detektor handelt es sich typischerweise um einen opto-elektrischen Wandler, z.B. um eine Photodiode, bspw. eine Avalanchediode, oder auch um einen Photomultiplier. Für Silikonelastomere kann z.B. eine Avalanchediode mit einer maximalen Empfindlichkeit im Bereich um etwa 800 nm zur Detektion von Elektrolumineszenzerscheinungen verwendet werden. Die fluoreszenzoptische Lichtleitfaser 20a kann direkt zur Auswerteeinheit 60 geführt werden. Es ist aber auch möglich, die fluoreszenzoptische Lichtleitfaser 20a über eine Transportlichtleitfaser 20b mit geringerer Dämpfung mit der Auswerteeinheit 60 zu verbinden.

Der leitfähige Deflektor 4 kann auf Grund seiner Dotierung intransparent sein. In diesem Fall, wird, wie in Fig. 1 gezeigt, die fluoreszenzoptische Lichtleitfaser 20a typischerweise so im Elastomerkörper 3 angeordnet, dass ein hinreichend langer Abschnitt der fluoreszenzoptischen Lichtleitfaser 20a außerhalb des Lichtschattens liegt, der für vom Bereich 8 mit erhöhter Feldstärke ausgehenden Lichtsignalen vom leitfähigen Deflektor 4 gebildet wird.

Außerdem ist es auch möglich, nicht nur eine fluoreszenzoptische Lichtleitfaser 20a mit einem Absorptionswellenlängenbereich, sondern mehrere mit aufeinander abgestimmten Absorptionsbereichen zumindest teilweise im Elastomerkörper einzubetten. Dadurch kann ein breiterer Ausschnitt aus dem Emissionsspektrum von Teilentladungen und/oder Elektrolumineszenz erfasst werden. Jede dieser fluoreszenzoptischen Lichtleitfasern kann über eine eigene Transportlichtleitfaser mit einem individuellen Detektor, z.B. einer auf den jeweiligen Fluophor angepassten individuellen Fotodiode in der Auswerteeinheit 60 verbunden werden. Die Signale der individuellen Fotodioden können dann bspw. einfach addiert werden, um ein integrales Maß für die Lichtleistung zu ermitteln.

Bei dem zweiten faseroptischen Sensor 30 handelt es sich um einen Sensor, der eine mechanische Größe in einem angrenzenden Medium, d.h. für das in Fig. 1 illustrierte Ausführungsbeispiel im Elastomerkörper 3, detektieren kann und dazu mit diesem mechanisch gekoppelt ist. Bei der mechanischen Größe kann es sich um eine Deformation und/oder eine Schwingung des Elastomerkörpers 3 handeln, die von einer Teilentladung verursacht wird. Insbesondere kann es sich um einen Schalldruck, eine Schallfrequenz, und/oder ein Frequenzspektrum handeln.

Auch der zweite faseroptische Sensor 30 kann über eine oder mehrer Versorgungsfasern 53 mit einem auf ihn abgestimmten Detektor in der Auswerteeinheit 60 gekoppelt sind und/oder von bzw. über die Auswerteeinheit 60 mit Prüfsignalen, z.B. Lasersignalen, versorgt werden.

Auf Grund der mechanischen Kopplung zwischen dem Feldsteuerteil 3, dem Isoliergebiet 2 und der Kabelisolierung 12 können vom zweiten faseroptischen Sensor 30 typischerweise auch Schallereignisse detektiert werden, die durch Teilentladungen im Isoliergebiet 2 oder der Kabelisolierung 12 verursacht werden.

Gemäß einer Ausführungsform ist der zweite faseroptische Sensor 30 ein Faserspitzensensor. Der Faserspitzensensor kann aus nur einer Faserspitze oder aus mehren Faserspitzen bestehen. Wenn eine Faserspitze in ein optisch transparentes oder transluzentes Medium, wie ein Silikonelastomer als Kabelisolierung, eingebettet wird oder an diese zumindest angrenzt, so kann anhand des an der Grenzfläche von Faserkern zum Medium rückgestreuten Lichts auf die optische Brechzahl und damit auf die Dichte des angrenzenden Elastomers geschlossen werden. Somit können Dichteveränderungen und/oder Oszillationen des Elastomers optisch über das rückgestreute Licht nachgewiesen werden.

Typischerweise ist der zweite faseroptische Sensor 30 ein phasensensitiver Sensor, z.B. ein interferometrischer Sensor. Der faseroptische Sensor 30 kann z.B. ein Fabry-Perot-Interferometer sein. Damit lassen sich besonders empfindliche Messungen realisieren.

Bei dem faseroptischen Sensor 30 kann es sich auch um einen Faser-Bragg-Gittersensor handeln mit dem sich insbesondere Lambwellen, d.h. gemischte Druck- und Scherwellen, detektieren lassen. Der Faser-Bragg-Gittersensor ist dabei typischerweise so ausgeführt, dass er irreversible Deformationen des Feldsteuerteils 3 und/oder Schallereignisse detektieren kann. Irreversible Deformationen des Feldsteuerteils 3 können von elektrischen Teilentladungen verursacht werden, aber auch elektrischen Teilentladungen vorausgehen. So kann es bspw. bei sehr großen Endverschlüssen mit Ausdehnungen von bis zu einigen Metern zu mechanischen Setzungserscheinungen der entsprechend schweren Komponenten kommen. Damit können Spannungen bzw. Verformungen des Feldsteuerteils 3 verbunden sein, die ihrerseits elektrische Teilentladungen begünstigen bzw. initiieren können. Mit einem Faser-Bragg-Gittersensor können somit auch elektrische Teilentladungen verursachende Strukturschädigungen detektiert werden.

Bei dem faseroptischen Sensor 30 kann es sich aber auch um einen quasiverteilten faseroptischen Sensor handeln. Dieser besteht aus einer Faser mit mehreren Messpunkten, die sich in regelmäßigen Abständen zueinander befinden. Über zeitbasierte Rückstreumessungen lassen sich irreversibel Deformationen und somit auch elektrische Teilentladungen verursachende Veränderungen im Feldsteuerteil 3 abschnittsweise entlang der Faser im Feldsteuerteil 3 detektieren.

Beide faseroptische Sensoren 20, 30 sind typischerweise so ausgeführt, dass sie nur aus dielektrischen Materialien besteht, z.B. aus Glas oder Polymerwerkstoff, und daher die elektrische Feldverteilung im Kabelendverschluss 100 gar nicht oder nur unwesentlich verändert. Außerdem werden derartige faseroptische Sensoren praktisch nicht durch äußere elektromagnetische Felder beeinflusst. Daher können die faseroptische Sensoren 20, 30 auch in der Nähe von Bereichen 8 mit besonders hoher Feldstärke, und daher in der Nähe von Risikobereichen, für das Detektieren von Elektrolumineszenzerscheinungen und/oder Teilentladungen positioniert werden. Damit kann eine empfindliche Überwachung des Alterungszustandes während des Betriebs, d.h. unter Hochspannungsbedingungen, sichergestellt werden. Dies erhöht die Sicherheit des Betriebs von Hochspannungsanlagen. Außerdem können die Messergebnisse oder die Messsignale über eine oder mehrere optische Versorgungsfasern 50 in eine zentrale Überwachungsstelle weitergeleitet werden, so dass aufwendige Messkampagnen vor Ort entfallen können. Auf Grund der geringen Faserdämpfung sind sogar faseroptische Messungen von einer zentralen Überwachungsstelle aus über große Entfernungen möglich.

Falls die effektive Dielektrizitätskonstante der faseroptischen Sensoren 20, 30 von der Dielektrizitätskonstante des Elastomerkörpers 3 abweicht, kann es zu einer Veränderung der elektrischen Feldverteilung im Elastomerkörper 3 kommen. Dann kann zusätzlich vorgesehen sein, dass die Form und/oder Leitfähigkeit des Feldsteuerkonus 4 so modifiziert wird, dass die Veränderung des elektrischen Feldes durch die faseroptischen Sensoren 20, 30 und/oder die optischen Versorgungsfasern 53 kompensiert wird.

Im Vergleich zu außerhalb der Hochspannungsgarnitur angeordneten elektromagnetischen oder piezoelektrischen Sensoren oder Messaufbauten ermöglicht die kombinierte Messung von optischen Signalen und mechanischen Größen mit auf die jeweilige Messung zugeschnittenen faseroptischen Sensoren 20, 30, die zudem typischerweise nahe den kritischen Bereichen 8 angeordnet sind, eine einfachere und/oder empfindlichere und/oder frühere Detektion von hochspannungsfeldverursachten Alterungsprozessen in der Isolierung 3.

Der erste faseroptische Sensor 20 kann zusätzlich oder alternativ eingerichtet sein, ein Lichtsignal einer Teilentladung des Elastomerkörpers 3 zu detektieren bzw. an die externe Auswerteeinheit weiterzuleiten. Damit können Teilentladungen vom ersten faseroptischen Sensor 20 und vom zweiten faseroptischen Sensor 30, d.h. mit unabhängigen Sensoren bzw. Verfahren, detektiert werden. Durch Korrelation der unabhängigen Messergebnisse können Fehlmessungen zumindest verringert und/oder die Teilentladung besser charakterisiert werden. Wenn zum Beispiel nur der zweite faseroptische Sensor 30 ein auf eine Teilentladung hinweisendes Signal detektiert, der erste faseroptische Sensor 20 aber kein damit verbundenes Lichtsignal detektiert, kann dies ein Hinweis auf eine externe mechanische Einwirkung oder Störung sein, insbesondere dann, wenn der erste faseroptische Sensor 20 später zusammen mit dem zweiten faseroptischen Sensor 30 ein Teilentladungsignal misst.

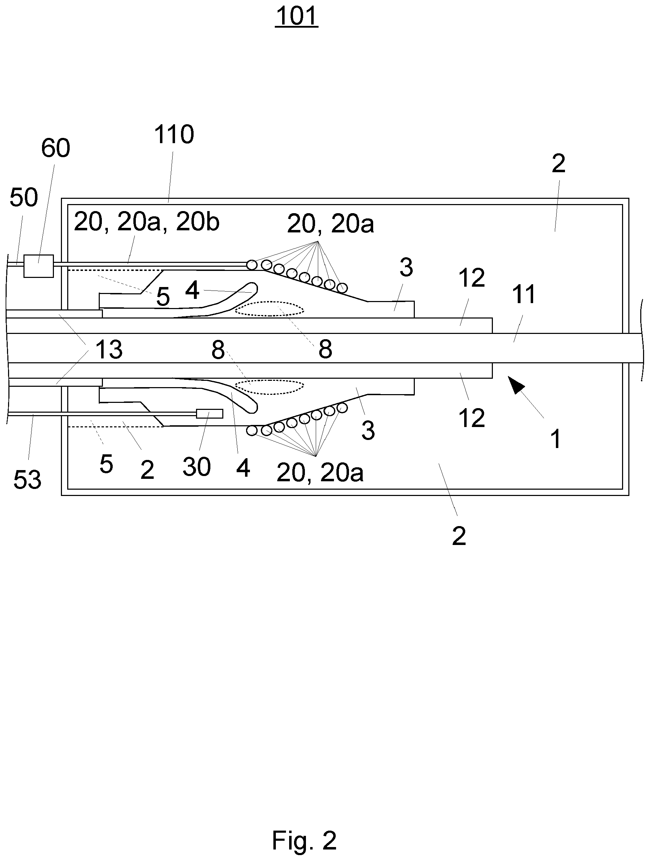

Fig. 2 zeigt eine Hochspannungsgarnitur 101 zur Aufnahme eines Hochspannungskabels 1 gemäß einem Ausführungsbeispiel in einer schematischen zentralen Querschnittsansicht entlang der Zylinderachse des Hochspannungskabels 1. Die Hochspannungsgarnitur 101 ist ähnlich zur Hochspannungsgarnitur 100 und stellt ebenfalls einen Kabelendverschluss dar. Die fluoreszenzoptische Lichtleitfaser 20a des ersten faseroptischen Sensors 20 ist beim Kabelendverschluss 101 jedoch auf einer Oberfläche des Elastomerkörpers 3 angeordnet, d.h. um den Elastomerkörper 3 gewickelt, wo sie ebenfalls ein im Elastomerkörper 3 entstehendes Lichtsignal aufsammeln, umwandeln und zum Detektor in der Auswerteeinheit 60 weiterleiten kann. Die fluoreszenzoptische Lichtleitfaser 20a kann zur Detektion sogar zumindest teilweise im Isoliergebiet 2 angeordnet sein, wenn dieses transparent oder transluzent ist, d.h. z.B. von einen transparenten Epoxidharzkörper oder Silikonkörper gebildet wird.

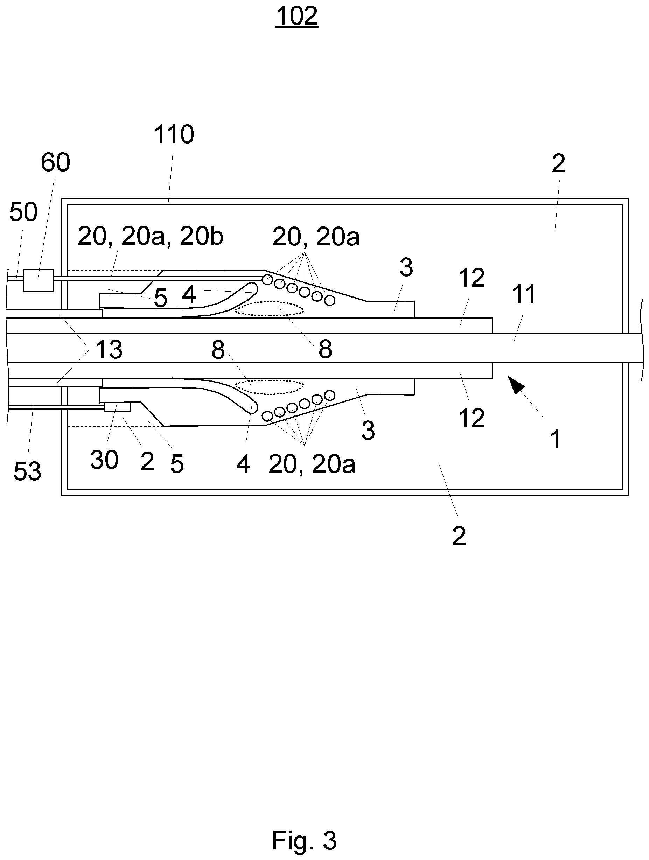

Fig. 3 zeigt eine Hochspannungsgarnitur 102 zur Aufnahme eines Hochspannungskabels 1 gemäß einem Ausführungsbeispiel in einer schematischen zentralen Querschnittsansicht entlang der Zylinderachse des Hochspannungskabels 1. Die Hochspannungsgarnitur 102 ist ähnlich zur Hochspannungsgarnitur 100 und stellt ebenfalls einen Kabelendverschluss dar. Der zweite faseroptische Sensor 30 ist beim Kabelendverschluss 102 jedoch auf einer Oberfläche des Elastomerkörpers 3 im feldfreien Gebiet 5 angeordnet, wo er ebenfalls eine mechanische Größe, z.B. eine ein Schallereignis charakterisierende Größe, messen kann. Alternativ dazu kann der zweite faseroptische Sensor 30 auch teilweise in den Elastomerkörper 3 eingebettet sein.

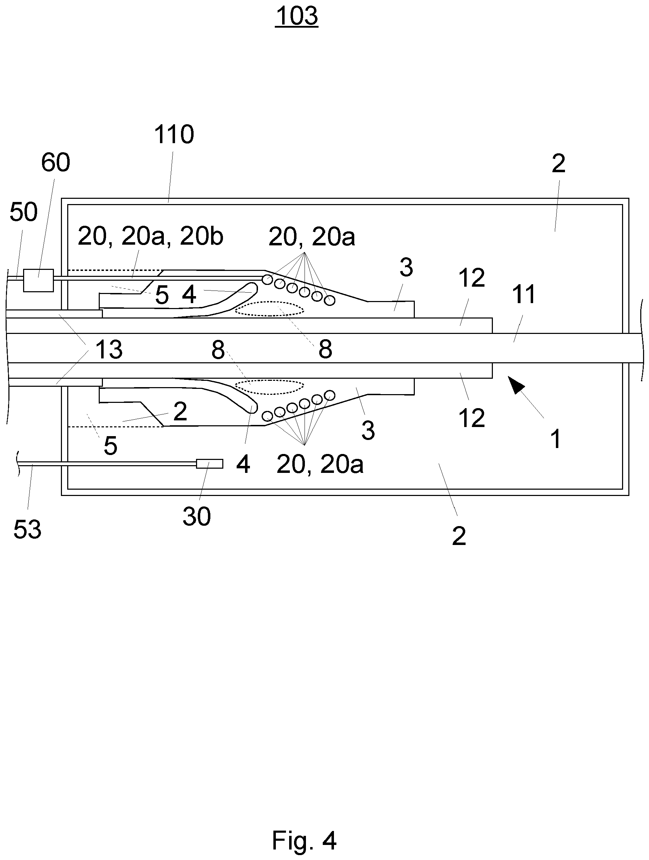

Fig. 4 zeigt eine Hochspannungsgarnitur 103 zur Aufnahme eines Hochspannungskabels 1 gemäß einem Ausführungsbeispiel in einer schematischen zentralen Querschnittsansicht entlang der Zylinderachse des Hochspannungskabels 1. Die Hochspannungsgarnitur 103 ist ähnlich zur Hochspannungsgarnitur 100 und stellt ebenfalls einen Kabelendverschluss dar. Der zweite faseroptische Sensor 30 ist beim Kabelendverschluss 103 jedoch in einem das Isoliergebiet 2 bildenden einem Isolierkörper eingebettet, wo er ebenfalls eine mechanische Größe, z.B. ein Schallpegel und/oder eine Schallfrequenz, messen kann, die auf Grund der mechanischen Kopplung zwischen dem Isolierkörper und dem Elastomerkörper 3 sowie der Kabelisolierung 12 auch zur Detektion einer Teilentladung im Elastomerkörper 3 bzw. der Kabelisolierung 12 verwendet werden kann.

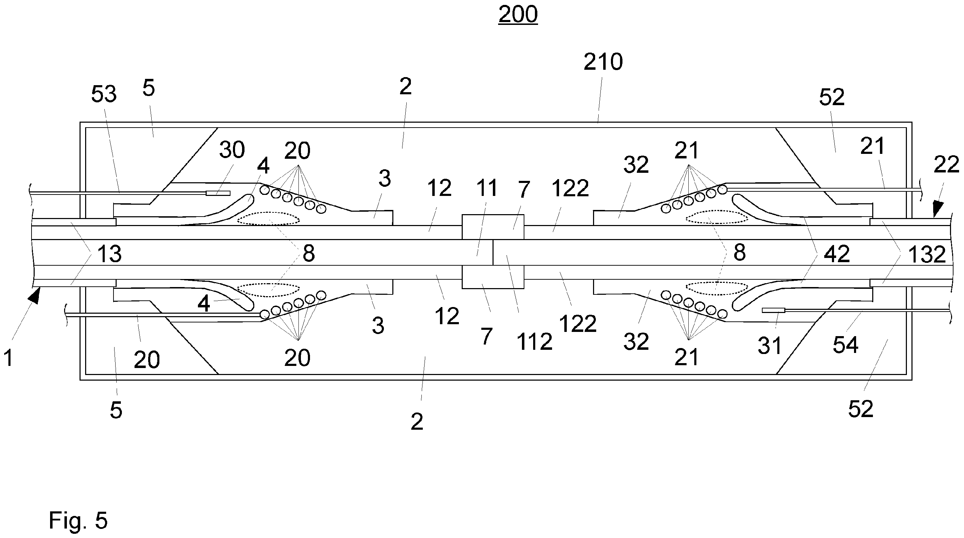

Fig. 5 zeigt eine Hochspannungsgarnitur 200 zur Aufnahme zweier Hochspannungskabel 1 und 22 gemäß einem Ausführungsbeispiel in einer schematischen zentralen Querschnittsansicht entlang der Zylinderachsen der koaxial orientierten Hochspannungskabel 1 und 22. Die rotationssymmetrischen Hochspannungskabel 1, 22 umfassen jeweils einen Leiter 11 bzw. 112 zum Leiten von Starkstrom und eine den jeweilige Leiter 11, 112 umgebende Kabelisolierung 12, 122. Die Hochspannungsgarnitur 200 stellt eine Hochspannungskabelmuffe zum Verbinden zweier Hochspannungskabel dar. Die Kabelmuffe 200 hat ein Gehäuse 210, z.B. ein Metallgehäuse, in dem die Hochspannungskabel 1 und 22 zentrisch angeordnet sind. Ein komplex aufgebauter elastomerer Muffenkonus mit Feldsteuerteilen 3, 32, die in ein Isoliergebiet 2 eingebettet sind und die das jeweils an den zusammengefügten Kabelenden auftretende Hochspannungsfeld definiert abbauen, übernimmt die Feldsteuerung der zu verbindenden Hochspannungskabel 1 und 22. Das Isoliergebiet 2 der Kabelmuffe 200 wird typischerweise von einem Gießharzisolator oder einem Silikonkörper gebildet. Weiterhin ist die Isolierung und Feldsteuerung im Bereich der verbundenen metallischen Leiter 11, 112 wieder herzustellen. Dies geschieht z.B. über eine Crimpverbindung und mit einem schwachleitfähigen Polymerring 7, die ebenfalls in das Isoliergebiet 2 eingebettet sind. Die typischerweise rotationssymmetrische Isolierung 2, 3, 32 der Kabelmuffe 200 wird von den Feldsteuerteilen 3, 23 und dem Isoliergebiet 2 gebildet. Außerdem kann das Isoliergebiet 2 durch eine nichtdargestellte äußere, leitfähige Muffenbeschichtung abgeschlossen sein, die auf der äußeren Oberfläche des Isoliergebiets 2 angeordnet ist, wobei ein kleiner Spalt zum Gehäuse 210 verbleiben kann, und die sich zusammen mit den Kabelschirmungen 13, 132 auf Erdpotential befindet. Typischerweise handelt es sich bei den Feldsteuerteilen 3, 32 um transparente oder transluzente elastomere Feldsteuerteile 3, 32, in die ein jeweiliger leitfähiger Deflektor 4, 42 integriert ist.

Die Kabelmuffe 200 kann in Komponentenbauweise, in Extrusionstechnik oder entsprechend der Wickeltechnik oder der Aufschiebetechnik ausgeführt sein. So kann die Isolierung der Kabelmuffe in Komponentenweise aus einem zusammenhängenden elastomeren Feldsteuerteil mit integrierten Deflektoren 4, 42 bestehen, das den Raum der in Fig. 5 gezeigten Feldsteuerteile 3, 32 und des Isoliergebiets 2 einnimmt, wobei ein kleiner Spalt zum Gehäuse 210 verbleiben kann, und das von einer äußeren, leitfähigen Muffenbeschichtung auf Erdpotential abgeschlossen ist. Die Isolierung umfasst aber unabhängig von der Herstellungstechnik zumindest ein Feldsteuerteil 3, 32 zur Aufnahme der Kabel 1, 22 mit an den jeweiligen Kabelenden entfernter Kabelisolierung 12, 122 und zur geeigneten Führung der Feldlinien im Hochspannungsbetrieb.

Gemäß einem Ausführungsbeispiel ist jeweils ein erste faseroptischer Sensor 20, 21 und ein zweiter faseroptischer Sensor 30, 31, wie sie mit Bezug zu den Figuren 1 bis 4 beschrieben wurden, zumindest teilweise in die Feldsteuerteile 3, 32 eingebettet. Dies bedeutet, dass es sich auch bei den ersten faseroptischen Sensoren 20, 21 der Hochspannungsmuffe 200 um Sensoren zur Detektion von in der Isolierung 2, 3, 32 und insbesondere in den Elastomerkörpern 3, 32 im Hochspannungsfeld entstehenden optischen Signalen bzw. Lichtsignalen handelt. Typischerweise sind die ersten faseroptischen Sensoren 20, 21 FOF-Sensoren. Aus Gründen der Übersichtlichkeit wird in Fig. 5 jedoch auf die Bezugszeichen für die fluoreszenzoptische Lichtleitfasern und die ggf. verwendeten Transportlichtleitfaser zum Verbinden mit einer ebenfalls nicht gezeigten Auswerteeinheit verzichtet. Bei den zweiten faseroptischen Sensoren 30, 31 der Kabelmuffe 200 handelt es sich um Sensoren, die eine Deformation insbesondere eine oszillierende Deformation z.B. eine Schwingung des jeweils umgebenden Mediums detektieren kann. Damit können auftretende Teilentladungen in der Isolierung der Kabelmuffe 200 sicher nachgewiesen und einfach über längere Zeiträume während des Hochspannungsbetriebs beobachtet werden. Die ersten und zweiten faseroptischen Sensoren 20, 21, 30, 31 ermöglichen daher ebenfalls eine einfache und/oder empfindliche und/oder sehr frühere Detektion von hochspannungsfeldverursachten Alterungsprozessen in der Isolierung.

Es versteht sich, dass die zweiten faseroptische Sensor 30, 31 zumindest teilweise auch im Isoliergebiet 2 und/oder auf einer Oberfläche des Isoliergebiets 2 angeordnet sein können. Falls das Isoliergebiet 2 von einem transparenten bzw. transluzenten Isolierkörper, z.B. einem transparenten Epoxidharzkörper, gebildet wird, so können die ersten faseroptischen Sensor 20, 21 ebenfalls zumindest teilweise im Isoliergebiet 2 und/oder auf einer Oberfläche des Isoliergebiets 2 angeordnet sein.

Außerdem können mehr als zwei erste faseroptische Sensoren 20, 21 und/ oder mehr als zwei zweite faseroptische Sensoren 30, 31 zumindest teilweise in die Isolierung 2, 3, 32 der Hochspannungsmuffe 200 angeordnet bzw. auf Oberflächen der Isolierung 2, 3, 32 angeordnet sein. Damit kann eine genauere und/oder fehlertolerantere Überwachung von Alterungszuständen der Kabelmuffe bereitgestellt werden. Beilspielsweise kann durch Verwendung mehrerer in ihrem Absorptionsspektrum aufeinander abgestimmter FOF-Sensoren als erste faseroptische Sensoren 20, 21 die Messempfindlichkeit weiter erhöht werden.

Mit Bezug zu den Figuren 1 bis 5 sind Ausführungsbeispiele von Kabelgarnituren beschrieben worden. In anderen Ausführungsbeispielen handelt es sich bei der Hochspannungseinrichtung um eine Schaltanlage, einen Generator, oder einen Spannungswandler, z.B. einen Transformator, mit einer transparenten oder transluzenten Isolierung, einem im Innern der Hochspannungseinrichtung angeordnet ersten faseroptischen Sensor zur Detektion eines optischen Signals in der Isolierung, und einem mit der Isolierung mechanisch gekoppelten zweiten faseroptischen Sensor zur Detektion einer mechanische Größe der Isolierung. Auch in diesen Hochspannungseinrichtungen kann durch Verwendung der beiden, unabhängige physikalische Prinzipien nutzenden, faseroptischen Sensoren eine zuverlässige Überwachung von Alterungsprozessen der Isolierung von einem sehr frühen Stadium vor dem Einsetzten der das Material der Isolierung nachhaltig schädigenden Teilentladungen an bis in den Bereich der Teilentladungen hinein erfolgen. Derartige Verfahren werden im Folgenden detailliert erläutert.

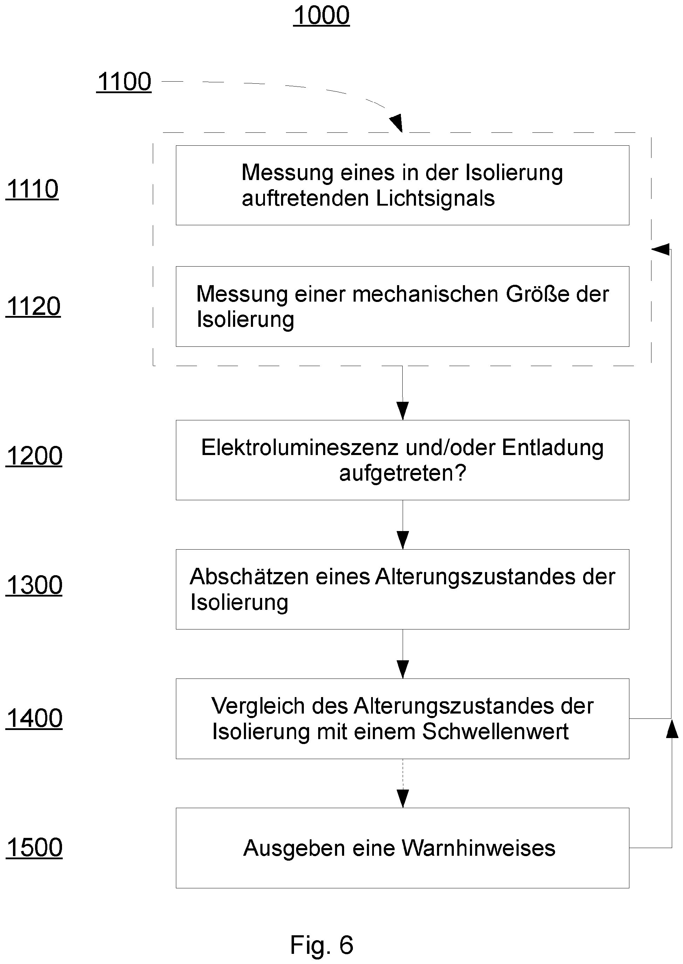

Fig. 6 illustriert Schritte eines Verfahrens 1000 zum Monitoring von Alterungsprozessen einer Isolierung einer Hochspannungseinrichtung gemäß einem Ausführungsbeispiel. Die Hochspannungseinrichtung enthält eine zumindest in Teilen transparente oder transluzente Isolierung zur Aufnahme eines Hochspannungskabels. Ein erster faseroptischer Sensor zur Detektion eines Lichtsignals ist im Innern der Hochspannungseinrichtung angeordnet. Außerdem ist ein zweiter faseroptischer Sensor zur Messung einer mechanischen Größe mechanisch mit der Isolierung gekoppelt. Beispielsweise kann es sich bei der Hochspannungseinrichtung um eine der mit Bezug zu den Figuren 1 bis 5 erläuterten Hochspannungseinrichtungen handeln.

In einem erstem Block 1100 erfolgt eine Messung 1110 eines in der Isolierung erzeugten Lichtsignals mit dem ersten faseroptischen Sensor und/oder eine Messung 1120 einer mechanischen Größe der Isolierung mit dem zweiten faseroptischen Sensor. Typischerweise werden im Block 1100 die Messergebnisse beider Messungen 1110, 1120 abgefragt. Auch das Vorliegen keines neuen oder geänderten Messergebnisses entspricht dabei einer Messung.

Die Messung 1110 kann dabei die Messung einer Lichtintensität, einer oder mehrerer Lichtwellenlängen und/oder einer Pulsdauer einer in der Isolierung auftretenden Elektrolumineszenz und/oder einer in der Isolierung auftretenden Teilentladung umfassen. Der erste faseroptische Sensor kann breitbandig ausgeführt sein oder aber empfindlich auf das erwartete Lichtsignal abgestimmt sein. So kann der erste faseroptische Sensor bei gegebenem Material der Isolierung und gegebener Spannung wellenlängenselektiv auf das erwartete Elektrolumineszenzsignal abgestimmt sein. Der erste faseroptische Sensor kann bei gegebenem Material der Isolierung und gegebener Spannung aber auch wellenlängenselektiv auf das erwartete Teilentladungssignal abgestimmt sein. Damit ist es möglich die jeweiligen Signale besonders empfindlich und/oder genau zu detektieren. Dies ist besonders für die typischerweise relativ schwachen Elektrolumineszenzsignale wichtig, damit diese möglichst frühzeitig detektiert werden können. Die Messung 1110 kann auch mittels mehrerer erster faseroptischer Sensoren ausgeführt werden, die für verschiedene Wellenlängen oder Wellenlängenbereiche selektiv sind.

Außerdem ist der erste faseroptische Sensor oder die ersten faseroptischen Sensoren typischerweise zumindest teilweise in die Isolierung eingebettet und damit relativ dicht zu den Bereichen der höchsten elektrischen Feldstärken angeordnet. Dadurch kann die Empfindlichkeit der Messung 1100 weiter gesteigert werden.

Die Messung 1120 umfasst typischerweise die Messung eines Drucks, einer Spannung, einer Deformation, einer Schwingung in der Isolierung und/oder einer ein Schallereignis charakterisierenden Größe. In einem Ausführungsbeispiel erfolgt die Messung 1120 im Frequenzbereich von etwa 10 kHz bis etwa 5 MHz, insbesondere im Bereich von etwa 10 kHz bis etwa 500 kHz, oder einem Teilbereich davon. Diese Frequenzbereiche sind charakteristisch für Schallereignisse, die von Teilentladung in der Isolierung verursacht werden. Auch die Messung 1120 kann mittels mehrerer zweiter faseroptischer Sensoren ausgeführt werden, die für verschiedene Frequenzen oder Frequenzbereiche selektiv sein können.

Typischerweise wird die Messung 1120 sensitiv auf Teilentladungen in der Isolierung und die Messung 1110 sensitiv auf Teilentladungen vorangehende Veränderungen der Isolierung ausgeführt. Damit kann ein Monitoring des Alterungszustandes von einem sehr frühen Alterungszustand bis in den Teilentladungsbereich hinein gewährleistet werden.

Gemäß einem Ausführungsbeispiel werden die Messungen 1110 und/oder 1120 mit jeweils mehreren faseroptischen Sensoren durchgeführt, was die Sicherheit der Messung erhöht und dazu genutzt werden kann, Ort und Zeit der Ereignisses genauer zu bestimmen. Um die drei Ortskoordinaten und den Zeitverlauf der Ereignisse bestimmen zu können werden zumindest vier Sensoren benötigt, die auch in den selben Frequenz-, bzw. Wellenlängenbereichen selektiv sein können.

Gemäß einem weiteren Ausführungsbeispiel werden die Messungen 1110 und 1120 im Block 1100 zeitlich kontinuierlich und im laufenden Betrieb der Hochspannungseinrichtung ausgeführt. Damit können Veränderungen der Isolierung lückenlos verfolgt werden. Unter dem Begriff einer "zeitlich kontinuierlichen Messung", wie er vorliegend verwendet wird, soll eine Messung verstanden werden, die auch einzelne kurze Signale im Bereich oberhalb einiger Millisekunden in einem Zeitraum von mehreren Stunden, typischerweise mehreren Tagen, oder sogar mehreren Wochen und Monaten detektieren kann. Die Messungen 1110 und 1120 im Block 1100 können aber auch zeitlich begrenzt während einer Prüfphase erfolgen, in der die Hochspannungseinrichtung mit elektrischen Prüfsignalen beaufschlagt wird.

Gemäß noch einem weiteren Ausführungsbeispiel werden die Messungen 1110 und 1120 von einer zentralen Auswerteeinheit gesteuert und überwacht. Damit können Alterungszustände von Isolierungen verschiedener Hochspannungseinrichtungen parallel überwacht werden.

Falls in Block 1110 bei der Messung 1110 ein Lichtsignal detektiert wurde und/oder bei der Messung 1120 eine geänderte oder sich ändernde mechanische Größe, z.B. eine geänderte Länge, geänderte mechanische Spannung, oder ein Schallereignis, detektiert wurde, kann, je nach Messergebnis, in einem sich anschließenden Block 1200 eine Wahrscheinlichkeit für das Auftreten einer Elektrolumineszenz und/oder Teilentladung sowie deren Stärke bestimmt. Beispielsweise kann aus einem wenig fluktuierenden Lichtsignal der Messung 1110 auf eine Elektrolumineszenzerscheinung in der Isolierung geschlossen werden. Demgegenüber kann aus einem hinreichend stark fluktuierenden Lichtsignal der Messung 1110 auf eine Entladungserscheinung in der Isolierung geschlossen werden, wobei die detektierte Lichtmenge und/oder Pulsdauer als Maß für die Stärke der Entladungserscheinung dienen kann. Je nach Material der Isolierung und Feldstärke kann dabei über Kalibrierkurven auch eine äquivalente scheinbare Entladung bestimmt werden und so das Auftreten einer Teilentladung detektiert und quantifiziert werden. Analog dazu kann aus einer charakteristischen Fluktuation eines bei der Messung 1120 detektierten Schallereignisses auf das Auftreten einer Teilentladung geschlossen werden, wobei eine gemessene Schallfrequenz, eine integrale Schallleistung und/oder der gemessene Schalldruck und/oder die gemessene Schalldauer ebenfalls zur Charakterisierung der Teilentladungsstärke verwendet werden können.

Block 1200 kann alternativ oder zusätzlich auch periodisch ausgeführt werden. Falls während einer Zeitperiode in Block 1110 bei der Messung 1110 kein Lichtsignal und bei der Messung 1120 keine geänderte oder sich ändernde mechanische Größe gemessen wurde, wird typischerweise davon ausgegangen, dass weder eine Elektrolumineszenzerscheinung noch eine Entladungserscheinung in der Isolierung aufgetreten ist.

In einem Block 1300 erfolgt dann eine Abschätzung eines Alterungszustandes der Isolierung. Dies erfolgt typischerweise periodisch und/oder wenn im Block 1200 eine Elektrolumineszenzerscheinung oder eine Entladungserscheinung detektiert bzw. in ihrer Stärke klassifiziert wurde. Außerdem wird der Block 1300 ebenso wie Block 1200 typischerweise auch von der zentralen Auswerteeinheit ausgeführt. Falls in Block 1200 weder eine Elektrolumineszenzerscheinung noch eine Entladungserscheinung detektiert wurde, so wird typischerweise davon ausgegangen, dass sich der Alterungszustand der Isolierung nicht geändert hat. Anderenfalls erfolgt eine Abschätzung des Alterungszustands der Isolierung. Dabei können die im Block 1100 gemessenen Signale miteinander und/oder mit früheren Messergebnissen korreliert werden, um die Messgenauigkeit weiter zu erhöhen. Je nach Messung wird der Alterungszustand der Isolierung angepasst. Typischerweise wird bei dem Auftreten oder andauerndem Auftreten von Elektrolumineszenz der Alterungszustand nur geringfügig angepasst. Demgegenüber wird beim Auftreten von Teilentladungen der Alterungszustand typischerweise stärker angepasst, wobei stärkere Teilentladung typischerweise zu einer stärkeren Anpassung des Alterungszustands führen. Für die Abschätzung eines fortgeschrittenen Alterungszustandes der Isolierung kann insbesondere die Länge eines Teilentladungsbäumchens in der Isolierung berücksichtigt werden, die z.B. mit mehreren zweiten faseroptischen Sensoren bestimmt werden kann.

Gemäß einem noch weiteren Ausführungsbeispiel erfolgt in einem weiteren Schritt 1400 ein Vergleich des ermittelten Alterungszustandes der Isolierung mit einem Schwellenwert. Dieser Schwellenwert kann z.B. ein Veränderungsgrad bzw. Schädigungsgrad, wie etwa die Größe einer Teilentladung oder eines Teilentladungsbäumchens, die Größe eines elektrolumineszierenden Gebietes oder eine andere zur erwarteten verbleibenden Zeitdauer bis zum elektrischen Durchbuch negativ korrelierte Größe sein. Wenn der Alterungszustand diesen Schwellenwert überschreitet, so erfolgt typischerweise in einem weiteren Schritt 1500 die Ausgabe eines Warnhinweises. Je nach Schwellenwert und Abstand des Alterungszustands zum Schwellenwert kann der Warnhinweis auch in Stufen steigender Dringlichkeit erfolgen. Danach beginnt typischerweise ein neuer Überwachungszyklus. Damit kann ein kontinuierliches Monitoring des Alterungszustandes der Isolierung während des Hochspannungsbetriebs bereitgestellt werden. Das Monitoring kann zudem von einer zentralen Auswerteeinheit gesteuert parallel an mehreren Isolierungen ausgeführt werden.

Bei einer neu installierten Isolierung bzw. einer neu installierten Hochspannungseinrichtung werden typischerweise nach einer gewissen Zeit zunächst nur optische Signale einer Elektrolumineszenz an der Isolierung gemessen, die ein Maß für einen geringen Veränderungsgrad bzw. eine lange Zeitdauer bis zum erwarteten elektrischen Durchbuch darstellen. Solange nur Elektrolumineszenzerscheinungen detektiert werden, ist wegen fehlender Teilentladungen von einer weiteren langen Lebensdauer der Isolierung auszugehen. Dementsprechend wird in Schritt 1500 typischerweise nur ein Warnsignal geringer Dringlichkeit ausgegeben. Ständige Elektrolumineszenz führt typischerweise jedoch über die damit verbundenenen Erosionsprozesse wie Mikrohohlraumbildung, Erweiterung der Hohlräume über kritische Abmessungen zu Entladungen geringer Intensität. Mit zunehmender Dauer der Elektrolumineszenz wird dementsprechend die Dringlichkeitsstufe des Warnhinweises typischerweise erhöht werden. Wenn zu einem späteren Zeitpunkt, z.B. vom zweiten faseroptischen Sensor über eine Schallmessung, erstmalig eine Teilentladung detektiert wird, wird die Dringlichkeitsstufe des Warnhinweises typischerweise ebenfalls erhöht. Mit Einsetzen des Wachstums der Teilentladungsbäumchen wird sich die Schallintensität typischerweise erhöhen und/oder das Schallspektrum ändern. Außerdem können sich dabei die Dauer und/oder die Häufigkeit von Teilentladungen erhöhen. Mit zunehmender Stärke, Häufigkeit, verändertem Frequenzspektrum und/oder Zeitdauer des detektierten Signals am zweiten faseroptischen Sensor wird dementsprechend die Dringlichkeitsstufe des Warnhinweises typischerweise weiter erhöht werden. In Abhängigkeit von Lagerbeständen können so Ersatzteile rechtzeitig bestellt werden. Die höchste Warnstufe wird typischerweise spätestens dann erreicht, wenn die elektrischen Teilentladungsbäumchen eine kritische Größe erreicht haben und eine Reparatur bzw. ein Austausch eingeleitet werden sollte, um einen Durchschlag zu verhindern. Damit können große wirtschaftliche Schäden und die Verletzungsgefahr für Anlagenpersonal durch die Zerstörung des Materials der Isolierung effizient vermieden werden.

Die Vorhersagegenauigkeit des Alterungszustandes kann dabei durch die Korrelation der Messungen mehrerer erster und/oder zweiter faseroptischer Sensoren weiter erhöht werden. So kann z.B. durch die Verwendung der Messdaten mehrerer zweiter faseroptischer Sensoren die Lage und/oder das Wachstum von Entladungsbäumchen überwacht werden. Damit lässt sich der Zeitpunkt und Ort eines bevorstehenden Durchschlags genauer bestimmen. Über eine Früherkennung von Teilentladungsbäumchen bzw. deren Wachstum und eine rechtzeitige Reparatur kann die Herausbildung kritischer Zerstörungsstrukturen, die einen Durchschlag einleiten, verhindert werden. Analog kann durch die Verwendung der Messdaten von Elektrolumineszenzereignissen mehrerer erster faseroptischer Sensoren das vorgeschädigte Volumen der Isolierung und/oder dessen Wachstum überwacht werden. Damit lassen sich der Ort und der Zeitpunkt einer bevorstehenden Teilentladung genauer bestimmen.

Die vorliegende Erfindung wurde anhand von Ausführungsbeispielen erläutert. Diese Ausführungsbeispiele sollten keinesfalls als einschränkend für die vorliegende Erfindung verstanden werden.

## Patentansprüche

1. Verfahren zum Monitoring von Alterungsprozessen einer Isolierung (2, 3, 32) in einer Hochspannungseinrichtung (100, 101, 102, 103, 200), umfassend:
- Messung eines in der Isolierung (2, 3, 32) erzeugten Lichtsignals mit einem ersten faseroptischen Sensor (20, 21), wobei der erste faseroptische Sensor (20, 21) eine fluoreszenzoptische Lichtleitfaser umfasst, wobei die Isolierung (2, 3, 32) ein zumindest in Teilgebieten transparentes oder transluzentes Feldsteuerteil (3, 32) umfasst, das eingerichtet ist, eine Kabelisolierung (12, 122) eines Hochspannungskabels (1, 22) zumindest teilweise zu umgeben und in das der erste faseroptische Sensor (20, 21) zumindest teilweise eingebettet ist und/oder auf dessen Oberfläche der erste faseroptische Sensor (20, 21) zumindest teilweise angeordnet ist, wobei die Messung des in der Isolierung (2, 3, 32) erzeugten Lichtsignals die Messung einer Lichtintensität, einer Lichtwellenlänge und/oder einer Pulsdauer einer in dem Feldsteuerteil (3, 32) auftretenden Elektrolumineszenzerscheinung und/oder einer in dem Feldsteuerteil (3, 32) auftretenden Entladungserscheinung mit einer scheinbaren Ladung von weniger als etwa 5 pC umfasst;
- Messung einer mechanischen Größe der Isolierung (2, 3, 32) mit einem mit der Isolierung (2,3,32) mechanisch gekoppelten zweiten faseroptischen Sensor (30, 31); und
- Abschätzen eines Alterungszustandes der Isolierung (2, 3, 32).

2. Verfahren nach Anspruch 1, wobei der zweite faseroptischen Sensor (30, 31) ein phasensensitiver Sensor ist.

3. Verfahren nach Anspruch 1 oder 2, wobei die Messung des in der Isolierung (2, 3, 32) erzeugten Lichtsignals die Messung einer Lichtintensität, einer Lichtwellenlänge und/oder einer Pulsdauer einer in dem Feldsteuerteil (3, 32) auftretenden Teilentladungserscheinung umfasst.

4. Verfahren nach einem der vorangegangenen Ansprüche, wobei die Messung der mechanischen Größe die Messung eines Drucks, einer Spannung, einer Deformation, eine eine Schwingung charakterisierenden Größe und/oder eine ein Schallereignis charakterisierenden Größe umfasst.

5. Verfahren nach einem der vorangegangenen Ansprüche, wobei die Messung der mechanischen Größe und/oder die Messung des in der Isolierung (2, 3, 32) erzeugten Lichtsignals zeitlich kontinuierlich und/oder ereignisgesteuert ausgeführt werden.

6. Verfahren nach einem der vorangegangenen Ansprüche, wobei das Verfahren im laufenden Betrieb der Hochspannungseinrichtung (100, 101, 102, 103, 200) ausgeführt wird.

7. Verfahren nach einem der vorangegangenen Ansprüche, wobei das Abschätzen eines Alterungszustandes der Isolierung (2, 3, 32) mindestens eine der folgenden Größen berücksichtigt:
- einen Schalldruck eines in der Isolierung (2, 3, 32) auftretenden Schallereignisses;
- eine Schallfrequenz eines in der Isolierung (2, 3, 32) auftretenden Schallereignisses;
- eine Schalldauer eines in der Isolierung (2, 3, 32) auftretenden Schallereignisses;
- eine integrale Lichtintensität des in der Isolierung (2, 3, 32) erzeugten Lichtsignals;
- eine Fluktuation einer Lichtintensität des in der Isolierung (2, 3, 32) erzeugten Lichtsignals; und
- eine Länge eines Teilentladungsbäumchens in der Isolierung (2, 3, 32).

8. Verfahren nach einem der vorangegangenen Ansprüche, weiter umfassend:
- Detektion einer Teilentladungserscheinung in der Isolierung (2, 3, 32); und/oder
- Detektion einer Elektrolumineszenzerscheinung in der Isolierung (2, 3, 32); und/oder
- Ausgeben eines Warnhinweises, wenn der Alterungszustand der Isolierung (2, 3, 32) einen vorgegebenen Schwellenwert überschreitet.

9. Hochspannungseinrichtung (100, 101, 102, 103, 200) zur Aufnahme eines Hochspannungskabels (1, 22) mit einem zum Leiten elektrischen Stroms eingerichteten Leiter (11, 112) und einer den Leiter (11, 112) umgebenden Kabelisolierung (12, 122), umfassend:
- eine Isolierung (2, 3, 32), die eingerichtet ist, die Kabelisolierung (12, 122) zumindest teilweise zu umgeben, wobei die Isolierung (2, 3, 32) ein zumindest in Teilgebieten transparentes oder transluzentes Feldsteuerteil (3, 32) umfasst, das eingerichtet ist, die Kabelisolierung (12, 122) zumindest teilweise zu umgeben;
- einen ersten faseroptischen Sensor (20, 21), der zumindest teilweise im Innern der Hochspannungseinrichtung (100, 101, 102, 103, 200) angeordnet ist und eingerichtet ist, ein Lichtsignals in der Isolierung (2, 3, 32) zu detektieren, wobei der erste faseroptische Sensor (20, 21) eine mit einem Fluophor dotierte Lichtleitfaser (20a) umfasst, wobei die dotierte Lichtleitfaser (20a) zumindest teilweise in das Feldsteuerteil (3) eingebettet und/oder auf einer Oberfläche des Feldsteuerteils (3) angeordnet ist, wobei das in der Isolierung erzeugte Lichtsignal ein Lichtsignal einer Elektrolumineszenzerscheinung im Feldsteuerteil (3) ist und/oder ein von einer Entladungserscheinung mit einer scheinbaren Ladung von weniger als 5 pC im Feldsteuerteil (3) erzeugtes Lichtsignal ist; und
- einen mit der Isolierung (2, 3, 32) mechanisch gekoppelten zweiten faseroptischen Sensor (30, 31), der eingerichtet ist, eine mechanische Größe zu detektieren.

10. Hochspannungseinrichtung (100, 101, 102, 103, 200) nach Anspruch 9, wobei die Hochspannungseinrichtung (100, 101, 102, 103, 200) eine Kabelmuffe (200), ein Kabelendverschluss (100, 101, 102, 103), ein Generator, ein Spannungswandler oder eine Schaltanlage ist.

11. Hochspannungseinrichtung (100, 101, 102, 103, 200) nach Anspruch 9 oder 10, wobei der zweite faseroptische Sensor (30, 31) ein phasensensitiver Sensor ist.

12. Hochspannungseinrichtung (100, 101, 102, 103, 200) nach Anspruch 11, wobei der zweite faseroptische Sensor (30, 31) zumindest teilweise in dem Feldsteuerteil (3, 32) eingebettet und/oder auf einer Oberfläche des Feldsteuerteils (3, 32) angeordnet ist.

13. Hochspannungseinrichtung (100, 101, 102, 103, 200) nach einem der Ansprüche 9 bis 12, wobei der zweite faseroptische Sensor (30, 31) eingerichtet ist, eine Teilentladung in dem Feldsteuerteil (3, 32) und/oder eine Deformation der Isolierung (2, 3, 32) und/oder eine Schallwelle in der Isolierung (2, 3, 32) zu detektieren.

14. Hochspannungseinrichtung (100, 101, 102, 103, 200) nach einem der Ansprüche 9 bis 13, wobei der erste faseroptische Sensor (20, 21) einen auf ein Emissionswellenspektrum des Fluophors der Lichtleitfaser (20a) abgestimmtem und mit der dotierten Lichtleitfaser (20a) gekoppelten optischen Detektor umfasst, und/oder wobei die Lichtleitfaser (20a) eine Vielzahl von Windungen um einen Bereich (8) mit erhöhter Feldstärke im Feldsteuerteil (3) während eines Hochspannungsbetriebs der Hochspannungseinrichtung bildet.

## Claims

1. A method for monitoring aging processes of an insulation (2, 3, 32) in a high-voltage device (100, 101, 102, 103, 200), comprising:
- measuring a light signal generated in the insulation (2, 3, 32) with a first optical fiber sensor (20, 21), wherein the first optical fiber sensor (20, 21) comprises an fluorescent optical fiber, wherein the insulation (2, 3, 32) comprises a field control part (3, 32) that is transparent or translucent, at least in regions, and that is configured to surround, at least in part, a cable insulation (12, 122) of a high-voltage cable (1, 22), wherein the first optical sensor (20, 21) is at least a partly embedded in and/or arranged on a surface of the field control part (3, 32), wherein measuring the light signal generated in the insulation (2, 3, 32) comprises a measurement of a light intensity, a light wavelength, and/or a pulse duration of an electroluminescent event occurring in the field control part (3, 32) and/or of a discharge event occurring in the field control part (3, 32) and having an apparent charge of less than about 5 pC;
- measuring a mechanical variable of the insulation (2, 3, 32) with a second optical fiber sensor (30, 31) mechanically coupled to the insulation (2, 3, 32); and
- estimating an aging status of the insulation (2, 3, 32).

2. The method according to claim 1, wherein the second optical fiber sensor (30, 31) is a phase-sensitive sensor.

3. The method according to claim 1 or 2, wherein measuring the light signal generated in the insulation (2, 3, 32) comprises a measurement of a light intensity, a light wavelength, and/or a pulse duration of a partial discharge event occurring in the field control part (3, 32).

4. The method according to any of the preceding claims, wherein measuring the mechanical variable comprises a measurement of a pressure, a voltage, a deformation, a variable characterizing a fluctuation, and/or a variable characterizing an acoustic event.

5. The method according to any of the preceding claims, wherein measuring the mechanical variable and/or measuring the light signal generated in the insulation (2, 3, 32) is executed temporally continuously and/or in an event-controlled manner.

6. The method according to any of the preceding claims, wherein the method is executed during operation of the high-voltage device (100, 101, 102, 103, 200).

7. The method according to any of the preceding claims, wherein estimating the aging status of the insulation (2, 3, 32) takes into account at least one of the following variables:
- an acoustic pressure of an acoustic event occurring in the insulation (2, 3, 32);
- an acoustic frequency of an acoustic event occurring in the insulation (2, 3, 32);
- an acoustic duration of an acoustic event occurring in the insulation (2, 3, 32);
- an integral light intensity of the light signal generated in the insulation (2, 3, 32);
- a fluctuation in a light intensity of the light signal generated in the insulation (2, 3, 32); and
- a length of a partial discharge tree in the insulation (2, 3, 32).

8. The method according to any of the preceding claims, further comprising:
- detection of a partial discharge event in the insulation (2, 3, 32); and/or
- detection of an electroluminescent event in the insulation (2, 3, 32); and/or
- output of a warning message if the aging status of the insulation (2, 3, 32) exceeds a specified threshold.

9. A high-voltage device (100, 101, 102, 103, 200) for receiving a high-voltage cable (1, 22) having a conductor (11, 112) configured for conducting electrical current and having a cable insulation (12, 122) surrounding the conductor (11, 112), comprising:
- an insulation (2, 3, 32) that is configured to surround the cable insulation (12, 122), at least in part, the insulation (2, 3, 32) comprising a field control part (3, 32) that is transparent or translucent, at least in part, and that is configured to surround the cable insulation (12, 122), at least in part;
- a first optical fiber sensor (20, 21), at least part of which is arranged in an interior of the high-voltage device (100, 101, 102, 103, 200) and that is configured to detect a light signal in the insulation (2, 3, 32), the first optical fiber sensor (20, 21) comprising an optical fiber (20a) doped with a fluorophore, wherein at least a part of the optical fiber (20a) is embedded in the field control part (3) and/or is arranged on a surface of the field control part (3), wherein the light signal generated in the insulation is a light signal of an electroluminescent event in the field control part (3) and/or is a light signal generated by a discharge event with an apparent charge of less than 5 pC in the field control part (3); and,
- a second optical fiber sensor (30, 31) that is mechanically coupled to the insulation (2, 3, 32) and that is configured to detect a mechanical variable.

10. The high-voltage device (100, 101, 102, 103, 200) according to claim 9, wherein the high-voltage device (100, 101, 102, 103, 200) is a cable sleeve (200), a cable termination (100, 101, 102, 103), a generator, a voltage transformer, or a switching device.

11. The high-voltage device (100, 101, 102, 103, 200) according to claim 9 or 10, wherein the second optical fiber sensor (30, 31) is a phase-sensitive sensor.

12. The high-voltage device (100, 101, 102, 103, 200) according to claim 11, wherein at least part of the second optical fiber sensor (30, 31) is embedded in the field control part (3, 32) and/or is arranged on a surface of the field control part (3, 32).

13. The high-voltage device (100, 101, 102, 103, 200) according to any of claims 9 through 12, wherein the second optical fiber sensor (30, 31) is configured to detect a partial discharge in the field control part (3, 32), a deformation of the insulation (2, 3, 32) and/or an acoustic wave in the insulation (2, 3, 32).

14. The high-voltage device (100, 101, 102, 103, 200) according to any of claims 9 through 13, wherein the first optical fiber sensor (20, 21) comprises an optical detector tuned to an emission wave spectrum of the fluorophore of the optical fiber (20a) and coupled to the optical fiber fiber (20a), and/or wherein the optical fiber (20a) forms a plurality of coils about a region (8) having increased field strength in the field control part (3) during high-voltage operation of the high-voltage device.

## Revendications

1. Procédé de surveillance de processus de vieillissement d'une isolation (2, 3, 32) dans un dispositif à haute tension (100, 101, 102, 103, 200), comprenant :
- la mesure d'un signal lumineux généré dans l'isolation (2, 3, 32) avec un premier capteur à fibre optique (20, 21), le premier capteur à fibre optique (20, 21) comprenant une fibre optique à fluorescence, l'isolation (2, 3, 32) comprenant une partie de contrôle de champ (3, 32) transparente ou translucide au moins dans certaines parties, qui est conçue pour entourer au moins partiellement une isolation de câble (12, 122) d'un câble à haute tension (1, 22) et dans laquelle le premier capteur à fibre optique (20, 21) est au moins partiellement intégré et/ou sur la surface de laquelle le premier capteur à fibre optique (20, 21) est au moins partiellement disposé, la mesure du signal lumineux généré dans l'isolation (2, 3, 32) comprenant la mesure d'une intensité lumineuse, d'une longueur d'onde de lumière et/ou d'une durée d'impulsion d'un phénomène d'électroluminescence survenant dans la partie de contrôle de champ (3, 32) et/ou d'un phénomène de décharge survenant dans la partie de contrôle de champ (3, 32) avec une charge apparente inférieure à environ 5 pC ;
- la mesure d'une grandeur mécanique de l'isolation (2, 3, 32) avec un deuxième capteur à fibre optique (30, 31) couplé mécaniquement avec l'isolation (2, 3, 32) ; et
- l'évaluation d'un état de vieillissement de l'isolation (2, 3, 32).

2. Procédé selon la revendication 1, le deuxième capteur à fibre optique (30, 31) étant un capteur sensible à la phase.

3. Procédé selon la revendication 1 ou 2, la mesure du signal lumineux généré dans l'isolation (2, 3, 32) comprenant la mesure d'une intensité lumineuse, d'une longueur d'onde de lumière et/ou d'une durée d'impulsion d'un phénomène de décharge partielle survenant dans la partie de contrôle de champ (3, 32).

4. Procédé selon l'une des revendications précédentes, la mesure de la grandeur mécanique comprenant la mesure d'une pression, d'une tension, d'une déformation, d'une grandeur caractérisant une vibration et/ou d'une grandeur caractérisant un événement sonore.

5. Procédé selon l'une des revendications précédentes, la mesure de la grandeur mécanique et/ou la mesure du signal lumineux généré dans l'isolation (2, 3, 32) sont effectuées de manière continue et/ou en fonction d'événements.

6. Procédé selon l'une des revendications précédentes, le procédé étant exécuté pendant le fonctionnement du dispositif à haute tension (100, 101, 102, 103, 200).

7. Procédé selon l'une des revendications précédentes, l'évaluation d'un état de vieillissement de l'isolation (2, 3, 32) prend en compte au moins une des grandeurs suivantes :
- pression acoustique d'un événement sonore survenant dans l'isolation (2, 3, 32) ;
- fréquence acoustique d'un événement sonore survenant dans l'isolation (2, 3, 32) ;
- durée acoustique d'un événement sonore survenant dans l'isolation (2, 3, 32) ;
- intensité lumineuse intégrale du signal lumineux généré dans l'isolation (2, 3, 32) ;
- fluctuation d'une intensité lumineuse du signal lumineux généré dans l'isolation (2, 3, 32) ; et
- longueur d'un arbre de décharge partiel dans l'isolation (2, 3, 32).

8. Procédé selon l'une des revendications précédentes, comprenant en outre :
- la détection d'un phénomène de décharge partielle dans l'isolation (2, 3, 32) ; et/ou
- la détection d'un phénomène d'électroluminescence dans l'isolation (2, 3, 32) ; et/ou
- le déclenchement d'une alarme lorsque l'état de vieillissement de l'isolation (2, 3, 32) dépasse une valeur seuil prédéterminée.

9. Dispositif à haute tension (100, 101, 102, 103, 200) pour le logement d'un câble à haute tension (1, 22) avec un conducteur (11, 112) conçu pour la conduction d'un courant électrique et une isolation de câble (12, 122) entourant le conducteur (11, 112), comprenant :
- une isolation (2, 3, 32) qui est conçue pour entourer au moins partiellement l'isolation de câble (12, 122), l'isolation (2, 3, 32) comprenant une partie de contrôle de champ (3, 32) transparent ou translucide au moins à certains endroits, qui est conçue pour entourer au moins partiellement l'isolation de câble (12, 122) ;
- un premier capteur à fibre optique (20, 21) qui est disposé au moins partiellement à l'intérieur du dispositif à haute tension (100, 101, 102, 103, 200) et qui est conçu pour détecter un signal lumineux dans l'isolation (2, 3, 32), le premier capteur à fibre optique (20, 21) comprenant une fibre optique (20a) dopée avec un fluorophore, la fibre optique (20a) dopée étant disposée de façon à être au moins partiellement intégrée dans la partie de contrôle de champ (3) et/ou sur une surface de la partie de contrôle de champ (3), le signal lumineux généré dans l'isolation étant un signal lumineux d'un phénomène d'électroluminescence dans la partie de contrôle de champ (3) et/ou un signal lumineux généré dans la partie de contrôle de champ (3) par un phénomène de décharge avec une charge apparente inférieure à 5 pC ; et
- un deuxième capteur à fibre optique (30, 31) couplé mécaniquement avec l'isolation (2, 3, 32), qui est conçu pour détecter une grandeur mécanique.

10. Dispositif à haute tension (100, 101, 102, 103, 200) selon la revendication 9, le dispositif à haute tension (100, 101, 102, 103, 200) étant un passe-câble (200), une cosse de câble (100, 101, 102, 103), un générateur, un convertisseur de tension ou une installation de commutation.

11. Dispositif à haute tension (100, 101, 102, 103, 200) selon la revendication 9 ou 10, le deuxième capteur à fibre optique (30, 31) étant un e capteur sensible à la phase.

12. Dispositif à haute tension (100, 101, 102, 103, 200) selon la revendication 11, le deuxième capteur à fibre optique (30, 31) étant intégré au moins partiellement dans la partie de contrôle de champ (3, 32) et/ou disposé sur une surface de la partie de contrôle de champ (3, 32).

13. Dispositif à haute tension (100, 101, 102, 103, 200) selon l'une des revendications 9 à 12, le deuxième capteur à fibre optique (30, 31) étant conçu pour détecter une décharge partielle dans la partie de contrôle de champ (3, 32) et/ou une déformation de l'isolation (2, 3, 32) et/ou une onde sonore dans l'isolation (2, 3, 32).

14. Dispositif à haute tension (100, 101, 102, 103, 200) selon l'une des revendications 9 à 13, le premier capteur à fibre optique (20, 21) comprenant un détecteur optique synchronisé avec un spectre d'émission du fluorophore de la fibre optique (20a) et couplé avec la fibre optique (20a) dopée, et/ou la fibre optique (20a) formant une pluralité de spires autour d'une zone (8) avec une forte intensité de champ dans la partie de contrôle de champ (3) pendant un fonctionnement à haute tension du dispositif à haute tension.
